# EUROPEAN PATENT APPLICATION

(11) **EP 4 467 581 A1**
(43) Date of publication of application: **27.11.2024**
(21) Application number: 22922186.6
(22) Date of filing: 22.12.2022
(51) Int. Cl.: C08F 220/26, C09D 133/04, C09D 201/06, G02B 5/20, G03F 7/004

(54) **SILICONE CHAIN-CONTAINING POLYMER, METHOD FOR PRODUCING SILICONE CHAIN-CONTAINING POLYMER, COATING COMPOSITION, RESIST COMPOSITION, AND ARTICLE**

(30) Priority: 18.01.2022 JP 2022005566
(71) Applicant: DIC Corporation, Tokyo 174-8520 (JP)
(72) Inventor: UENO Junpei, Ichihara-shi, Chiba 290-8585 (JP); HATASE Masaki, Ichihara-shi, Chiba 290-8585 (JP); NOGUCHI Jun, Ichihara-shi, Chiba 290-8585 (JP); SHIMIZU Ryohei, Ichihara-shi, Chiba 290-8585 (JP); NOGUCHI Yuuki, Ichihara-shi, Chiba 290-8585 (JP); SASAMOTO Shin, Ichihara-shi, Chiba 290-8585 (JP); SUZUKI Hideya, Ichihara-shi, Chiba 290-8585 (JP)
(74) Representative: TBK
(86) International application number: PCT/JP2022/047259
(87) International publication number: WO 2023/140036

(57) **Abstract**

Provided is a silicone chain-containing polymer functioning as a leveling agent which imparts high smoothness and the effect of suppressing pin unevenness to a coating film. Specifically, a silicone chain-containing polymer includes, as polymerization components, a polymerizable monomer (1) having a group containing a structure represented by general formula (A) below and a polymerizable monomer (2) having one or more selected from an alkyl group having 1 to 18 carbon atoms, an aromatic group having 6 to 18 carbon atoms, and a group containing a polyoxyalkylene chain. In the polymer, the ratio of the polymerizable monomer (1) in the polymerization components is 20% by weight or less, and the weight-average molecular weight is 15,000 or more.

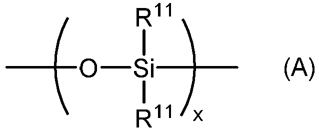

## Description

### Technical Field

The present invention relates to a silicone chain-containing polymer, a method for producing a silicone chain-containing polymer, a coating composition, a resist composition, and an article.

### Background Art

A leveling agent is added for smoothing a coating film obtained by coating a coating composition such as a coating material composition, a resist composition, or the like. Specifically, when a leveling agent is added to a coating composition, the leveling agent is aligned on the surface of a coating film and decreases surface tension of the coating film, and thus the function of smoothing the resultant coating film can be obtained. The coating film having a smoothed surface can improve the occurrence of cissing and unevenness.

The leveling agent is used for, for example, an automobile coating material, and a coating material composition containing the leveling agent can impart high smoothness to the surface of the resultant coating film and can give gloss to the appearance of an automobile.

A silicone-based leveling agent is proposed as the leveling agent, and a leveling agent having a relatively short silicone chain (for example, Patent Literature 1) and a leveling agent having a relatively long silicone chain (for example, Patent Literature 2) are also proposed.

The leveling agent is used for various applications, and is, for example, also used for a color resist composition used for forming a color filter for a liquid crystal display. The production of a color filter generally includes a step of coating a color resist composition on a glass substrate by a coating method such as spin coating, slit coating, or the like, exposing the coating film using a mask after drying, and then developing the film to form a colored pattern. In this case, when there is unevenness of the film thickness due to poor smoothness of the coating film or when there is coating unevenness, cissing, or the like, color unevenness may occur in pixels.

The addition of the leveling agent to the color resist composition can improve the smoothness of the resultant coating film, and can exhibit high smoothness of the surfaces of red (R), green (G), and blue (B) pixels and of the black matrix (BM) formed between these pixels, and thus a color filter with little color unevenness can be obtained.

### Citation List

### Patent Literature

PTL 1: Japanese Unexamined Patent Application Publication No. 2003-226834
PTL 2: Japanese Unexamined Patent Application Publication No. 2018-532824

### Summary of Invention

### Technical Problem

As described above, a coating film formed by coating a coating composition, containing a leveling agent, on a substrate can exhibit high smoothness. The coating film is generally dried in a vacuum drying device for evaporating the solvent in the coating film, and the coating film on the substrate is supported by support pins and dried in a chamber of the drying device. In this case, there is a problem that a temperature difference occurs between a portion where each of the support pins is in contact with the substrate and other portions, thereby causing pin unevenness (drying unevenness) due to a difference in drying rate. The pin unevenness is hardly solved even by adding the leveling agent.

A problem to be solved by the present invention is to provide a silicone chain-containing polymer functioning as a leveling agent which imparts high smoothness and the effect of suppressing pin unevenness to a coating film.

### Solution to Problem

As a result of earnest research for solving the problem, the inventors found that in a silicone chain-containing polymer containing as a polymerization component a polymerizable monomer having a specific silicone chain, when the ratio of the polymerizable monomer having a silicone chain to the polymerization component is within a specific range, and the weight-average molecular weight of the silicone chain-containing polymer is within a specific range, the silicone chain-containing polymer imparts high smoothness and the effect of suppressing pin unevenness to the coating film, leading to the achievement of the present invention.

That is, the present invention relates to a silicone chain-containing polymer containing, as polymerization components, a polymerizable monomer (1) having a group containing a structure represented by general formula (A) below and a polymerizable monomer (2) having one or more selected from an alkyl group having 1 to 18 carbon atoms, an aromatic group having 6 to 18 carbon atoms, and a group containing a polyoxyalkylene chain, in which the ratio of the polymerizable monomer (1) in the polymerization components is 20% by weight or less, and the weight-average molecular weight is 15,000 or more. 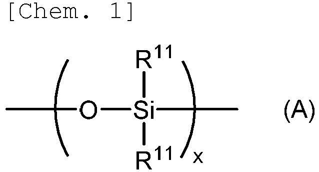 (In the formula (A),
R¹¹s are each independently an alkyl group having 1 to 6 carbon atoms;
x represents a repeat number; and an average number value thereof is 20 or more.)

### Advantageous Effects of Invention

The present invention can provide a silicone chain-containing polymer functioning as a leveling agent which imparts high smoothness and the effect of suppressing cissing to a coating film.

### Description of Embodiments

An embodiment of the present invention is described below. The present invention is not limited to the embodiment below and can be carried out by adding proper modification within a range not impairing the effect of the present invention.

In the present specification, "(meth)acrylic acid" represents one or both of acrylic acid and methacrylic acid.

### [Silicone chain-containing polymer]

A silicone chain-containing polymer (may be simply referred to as a "polymer of the present invention" hereinafter) of the present invention is a silicone chain-containing polymer containing, as polymerization components, a polymerizable monomer (1) having a group containing a structure represented by general formula (A) below and a polymerizable monomer (2) having one or more selected from an alkyl group having 1 to 18 carbon atoms, an aromatic group having 6 to 18 carbon atoms, and a group containing a polyoxyalkylene chain, in which the ratio of the polymerizable monomer (1) to the polymerization components is 20% by weight or less, and the weight-average molecular weight is 15,000 or more. 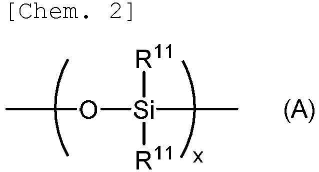 (In the formula (A),
R¹¹s are each independently an alkyl group having 1 to 6 carbon atoms;
x represents a repeat number; and an average number value thereof is 20 or more.)

In the present invention, the "polymerizable monomer" represents a compound having a polymerizable unsaturated group, and examples of a polymerizable unsaturated group possessed by the polymerizable monomer (1) and the polymerizable monomer (2) include C=C containing groups, such as a (meth)acryloyl group, a(meth)acryloyloxy group, a (meth)acryloylamino group, a vinyl ether group, an allyl group, a styryl group, a maleimide group, and the like. Among these, in view of easy availability of raw materials and good polymerization reactivity, a (meth)acryloyl group and a (meth)acryloyloxy group are preferred.

The number of polymerizable unsaturated groups possessed by the polymerizable monomer may be 1 or 2 or more.

In the present invention, the "polymerization component" represents a component constituting a polymer and does not include a solvent and a polymerization initiator which do not constitute a polymer.

The group containing a structure represented by the general formula (A) is preferably a group represented by general formula (A1) below. 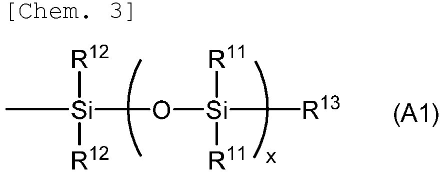 (In the formula (A1),
R¹¹s are each independently an alkyl group having 1 to 6 carbon atoms;
R¹²s are each independently an alkyl group having 1 to 6 carbon atoms;
R¹³ is an alkyl group having 1 to 6 carbon atoms;
x represents a repeat number; and an average number value thereof is 20 or more.)

In the general formulae (A) and (A1), R¹¹, R¹², and R¹³ are preferably methyl groups.

In the general formulae (A) and (A1), the average number value of x in the polymer of the present invention is 20 or more, preferably within a range of 30 to 300, more preferably within a range of 40 to 200, and still more preferably within a range of 50 to 150.

In the present invention, with respect to the polymerizable monomer (1) constituting the polymer of the present invention, the "average number value of x" represents the average of the number of repeating units of siloxane bonds per polymerizable monomer.

The average number value of x" in the polymer of the present invention can be calculated from the number-average molecular weight of the polymer of the present invention.

In the general formulae (A) an (A1), the lower limit of the average number value of x in the polymer of the present invention is 20 or more, and thus even when the ratio of the polymerizable monomer (1) is 20% by weight or less, the polymer of the present invention can exhibit the high ability to decrease surface tension and can suppress pin unevenness due to uniform evaporation of the solvent contained in a coating solution.

The polymerizable monomer (1) is preferably a compound represented by general formula (1-1) below. 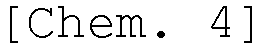 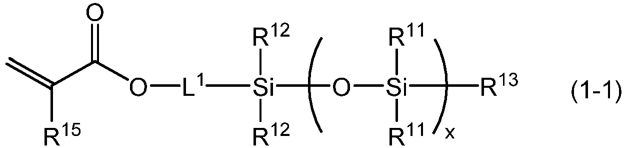 (In the general formula (1-1), R¹¹, R¹², R¹³, and x are the same as R¹¹, R¹², R¹³, and x, respectively, in the general formulae (A) and (A1);
R¹⁵ is a hydrogen atom or a methyl group; and
L¹ is a divalent organic group.)

The divalent organic group as L¹ is preferably a single bond, an alkylene group having 1 to 50 carbon atoms, or an alkyleneoxy group having 1 to 50 carbon atoms.

Examples of the alkylene group having 1 to 50 carbon atoms as L¹ include a methylene group, an ethylene group, a n-propylene group, a n-butylene group, a n-pentylene group, a n-hexylene group, a n-heptylene group, a n-octylene group, a n-nonylene group, a n-decylene group, a n-dodecylene group, an isopropylene group, a 2-methylpropylene group, a 2-methylhexylene group, a tetramethylethylene group, and the like.

The alkylene group having 1 to 50 carbon atoms as L¹ is preferably an alkylene group having 1 to 15 carbon atoms, more preferably an alkylene group having 1 to 5 carbon atoms, and still more preferably a methylene group, an ethylene group, a n-propylene group, or an isopropylene group.

The alkyleneoxy group having 1 to 50 carbon atoms as L¹ is, for example, a group in which one -CH₂- in the alkylene group is substituted by -O-.

The alkyleneoxy group having 1 to 50 carbon atoms as L¹ is preferably an alkyleneoxy group having 1 to 15 carbon atoms, more preferably an alkyleneoxy group having 1 to 8 carbon atoms, and still more preferably a methyleneoxy group, an ethyleneoxy group, a n-propyleneoxy group, an oxytrimethylene group, a butyleneoxy group, an oxytetramethylene group, a pentyleneoxy group, a heptyleneoxy group, or an octyleneoxy group.

When the divalent organic group as L1 is an alkylene group having 1 to 50 carbon atoms or an alkyleneoxy group having 1 to 50 carbon atoms, -CH₂- of the divalent organic group may be partially substituted by a carbonyl group (-C(=O)-), a phenylene group, an amide bond, or a urethane bond, and a hydroxyl group or the like may be further substituted at a carbon atom.

The polymerizable monomer (1) can be produced by a known method and a commercial product may be used.

The polymerizable monomer (2) as a polymerization component of the polymer of the present invention, which has one or more selected from an alkyl group having 1 to 18 carbon atoms, an aromatic group having 6 to 18 carbon atoms, and a group containing a polyoxyalkylene chain has, for example, the function of securing compatibility.

An alkyl group having 1 to 18 carbon atoms possessed by the polymerizable monomer (2) may be any one of a linear alkyl group, a branched alkyl group, and a cyclic alkyl group, and examples thereof include a methyl group, an ethyl group, a normal propyl group, an isopropyl group, a n-butyl group, a tert-butyl group, a n-hexyl group, a cyclohexyl group, a n-octyl group, a hexadecyl group, and the like.

The alkyl group having 1 to 18 carbon atoms possessed by the polymerizable monomer (2) may be substituted by one or more substituents such as a hydroxyl group, a phenyl group, a phenoxy group, and the like.

Examples of the alkyl group having 1 to 18 carbon atoms possessed by the polymerizable monomer (2) include a hydroxyalkyl group having 1 to 18 carbon atoms, a phenylalkyl group having 7 to 18 carbon atoms, and a phenoxyalkyl group having 7 to 18 carbon atoms.

The alkyl group having 1 to 18 carbon atoms possessed by the polymerizable monomer (2) is preferably an alkyl group having 1 to 8 carbon atoms.

Examples of the aromatic group having 6 to 18 carbon atoms possessed by the polymerizable monomer (2) include a phenyl group, a naphthyl group, an anthracen-1-yl group, a phenathren-1-yl, and the like.

The aromatic group having 6 to 18 carbon atoms possessed by the polymerizable monomer (2) may be further substituted by a substituent such as a hydroxyl group, an alkyl group, an alkoxy group, or the like, and examples thereof include a phenyl group substituted by an alkyl group having 1 to 6 carbon atoms.

The group containing a polyoxyalkylene chain possessed by the polymerizable monomer (2) is a monovalent group containing an oxyalkylene repeating part or a divalent linking group containing an oxyalkylene repeating part.

The polymerizable monomer (2) may be one or more selected from a polymerizable monomer having an alkyl group having 1 to 18 carbon atoms, a polymerizable monomer having an aromatic group having 6 to 18 carbon atoms, and a polymerizable monomer having a group containing a polyoxyalkylene chain, and a polymerizable monomer having a group containing a polyoxyalkylene chain is preferably necessarily contained as the polymerizable monomer (2),

Examples of the polymerizable monomer (2) having an alkyl group having 1 to 18 carbon atoms and a (meth)acryloyl group as the polymerizable unsaturated group include (meth)acrylic acid alkyl esters having 1 to 18 carbon atoms, such as methyl (meth)acrylate, ethyl (meth)acrylate, n-propyl (meth)acrylate, isopropyl (meth)acrylate, n-butyl (meth)acrylate, s-butyl (meth)acrylate, isobutyl (meth)acrylate, tert-butyl(meth)acrylate, n-pentyl (meth)acrylate, n-hexyl (meth)acrylate, n-heptyl (meth)acrylate, n-octyl (meth)acrylate, 2-ethylhexyl (meth)acrylate, decyl (meth)acrylate, dodecyl (meth)acrylate, stearyl (meth)acrylate, isostearyl (meth)acrylate, and the like; (meth)acrylic acid crosslinked cyclic alkyl esters having 1 to 18 carbons, such as dicyclopentanyloxyl ethyl (meth)acrylate, isobornyloxyl ethyl (meth)acrylate, isobornyl (meth)acrylate, adamantyl (meth)acrylate, dimethyl adamantyl (meth)acrylate, dicyclopentanyl (meth)acrylate, dicyclopentenyl (meth)acrylate, and the like; and the like.

Examples of the polymerizable monomer (2) having a hydroxyalkyl group having 1 to 18 carbon atoms and a (meth)acryloyl group as the polymerizable unsaturated group include 2-hydroxyethyl (meth)acrylate, 2-hydroxypropyl (meth)acrylate, 2-hydroxybutyl (meth)acrylate, 4-hydroxy (meth)acrylate, 1,4-cyclohexane dimethanol
mono(meth)acrylate, 2,3-dihydroxypropyl (meth)acrylate, and the like.

Examples of the polymerizable monomer (2) having a phenylalkyl group having 7 to 18 carbon atoms or a phenoxyalkyl group having 7 to 18 carbon atoms and a (meth)acryloyl group as the polymerizable unsaturated group include benzyl (meth)acrylate, 2-phenoxymethyl
(meth)acrylate, 2-phenoxyethyl (meth)acrylate, 2-hydroxy-3-phenoxypropyl (meth)acrylate, and the like.

Examples of the polymerizable monomer (2) having a group containing a polyoxyalkylene chain and a (meth)acryloyl group as the polymerizable unsaturated group include polypropylene glycol mono(meth)acrylate, polyethylene glycol mono(meth)acrylate, polytrimethylene glycol mono (meth)acrylate, polytetramethylene glycol mono(meth)acrylate, poly(ethylene glycol-propylene glycol) mono(meth)acrylate, polyethylene glycol-polypropylene glycol mono(meth)acrylate, poly(ethylene glycol-tetramethylene glycol) mono(meth)acrylate, polyethylene glycol-polytetramethylene glycol mono(meth)acrylate, poly(propylene glycol-tetramethylene glycol)
mono(meth)acrylate, polypropylene glycol-polytetramethylene glycol mono(meth)acrylate, poly(propylene glycol-1,2-butylene glycol) mono(meth)acrylate, polypropylene glycol-poly-1,2-butylene glycol mono(meth)acrylate, poly(ethylene glycol-1,2-butylene glycol) mono(meth)acrylate, polyethylene glycol-poly-1,2-butylene glycol mono(meth)acrylate, poly(tetraetylene glycol-1,2-butylene glycol)
mono(meth)acrylate, polytetraethylene glycol-poly-1,2-butylene glycol mono(meth)acrylate, poly-1,2-butylene glycol mono(meth)acrylate, poly(ethylene glycol-trimethylene glycol) mono(meth)acrylate, polyethylene glycol-polytrimethylene glycol mono(meth)acrylate, poly(propylene glycol-trimethylene glycol) mono(meth)acrylate, polypropylene glycol-polytrimethylene glycol mono(meth)acrylate, poly(trimethylene glycol-tetramethylene glycol) mono(meth)acrylate, polytrimethylene glycol-polytetramethylene glycol mono(meth)acrylate, poly(1,2-buylene glycol-trimethylene glycol) mono(meth)acrylate, poly-1,2-butylene glycol-polytrimethylene glycol mono(meth)acrylate, 2-hydroxyethyl (meth)acrylate, 2-hydroxypropyl (meth)acrylate, 2-hydroxybutyl (meth)acrylate, 4-hydroxybutyl (meth)acrylate, poly(1,2-butylene glycol-tetramethylene glycol) mono(meth)acrylate, poly-1,2-buylene glycol-polytetramethylene glycol mono(meth)acrylate, and the like.

The "poly(ethylene glycol-propylene glycol)" described above represents a random copolymer of ethylene glycol and propylene glycol, and the "polyethylene glycol-polypropylene glycol" represents a block copolymer of ethylene glycol and propylene glycol.

Examples of the polymerizable monomer (2) having a alkyl group having 1 to 18 carbon atoms and a vinyl ether group as the polymerizable unsaturated group include alkyl vinyl ethers such as methyl vinyl ether, ethyl vinyl ether, n-propyl vinyl ether, isopropyl vinyl ether, n-butyl vinyl ether, isobutyl vinyl ether, tert-butyl vinyl ether, n-pentyl vinyl ether, n-hexyl vinyl ether, n-octyl vinyl ether, n-dodecyl vinyl ether, 2-ethyl hexyl vinyl ether, cyclohexyl vinyl ether, and the like; cycloalkyl vinyl ether, 2-hydroxyethyl vinyl ether, 3-hydroxypropyl vinyl ether, 4-hydroxybutyl vinyl ether, 5-hydroxypentyl vinyl ether, 6-hydroxyhexyl vinyl ether, 1-hydroxypropyl vinyl ether, 2-hydroxypropyl vinyl ether, 1-hydroxybutyl vinyl ether, 2-hydroxybutyl vinyl ether, 3-hydroxybutyl vinyl ether, 3-hydroxy-2-methyl propyl vinyl ether, 4-hydroxy-2-methyl butyl vinyl ether, 4-hydroxycyclohexyl vinyl ether, cyclohexane-1,4-dimethanol monovinyl ether, and the like.

Examples of the polymerizable monomer (2) having an alkyl group having 1 to 18 carbon atoms and an allyl group as the polymerizable unsaturated group include 2-hydroxyethy allyl ether, 4-hydorxybutyl allyl ether, glycerol monoallyl ether, and the like.

Examples of the polymerizable monomer (2) having an aromatic group having 6 to 18 carbon atoms include styrene, α-methylstyrene, p-methylstyrene, p-methoxystyrene, and the like.

Examples of the polymerizable monomer (2) having an alkyl group having 1 to 18 carbon atoms and a (meth)acryloylamino group as the polymerizable unsaturated group include N,N-dimethylacrylamide, N,N-diethylacrylamide, N-isopropylacrylamide, diacetone acrylamide, acryloylmorpholine, and the like.

Examples of the polymerizable monomer (2) having an alkyl group having 1 to 18 carbon atoms and a maleimide group as the polymerizable unsaturated group include methyl maleimide, ethyl maleimide, propyl maleimide, butyl maleimide, hexyl maleimide, octyl maleimide, dodecyl maleimide, stearyl maleimide, cyclohexyl maleimide, and the like.

The polymerizable monomer (2) is preferably a compound represented by general formula (2-1) below and/or a compound represented by general formula (2-2) below. These compounds can impart compatibility when the polymer of the present invention is used as the leveling agent. 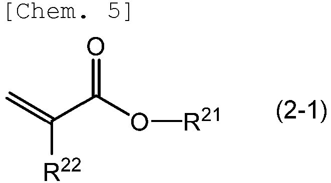 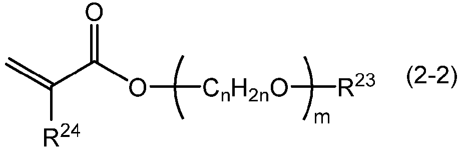 (In the general formulae (2-1) and (2-2),
R²¹ is an alkyl group having 1 to 18 carbon atoms;
R²² is a hydrogen atom or a methyl group;
R²³ is a hydrogen atom or an alkyl group having 1 to 18 carbon atoms;
R²⁴ is a hydrogen atom or a methyl group;
n is an integer within a range of 1 to 4; and m is an

### integer within a range of 1 to 200.

In the formula (2-2), n of CₙH₂ₙO in parenthesis may be the same as or different from each other for the repeating units. Also, when n is 2 or more, two or more repeating units may be random-polymerized or block-polymerized.

In the general formulae (2-1) and (2-2), an alkyl group having 1 to 18 carbon atoms as each of R²¹ and R²³ is preferably an alkyl group having 1 to 8 carbon atoms.

In the general formula (2-2), m is preferably an integer within a range of 2 to 50 and more preferably an integer within a range of 3 to 20.

The polymerizable monomer (2) is preferably a compound represented by general formula (2-3) below. 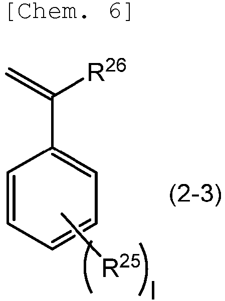 (In the general formula (2-3),
R²⁵s are each independently an alkyl group having 1 to 6 carbon atoms or an alkoxy group having 1 to 6 carbon atoms;
R²⁶ is a hydrogen atom or a methyl group; and
1 is an integer of 0 to 5.)

The polymerizable monomer (2) can be produced by a known method.

Also, a commercial product may be used as the polymerizable monomer (2). Examples of a commercial product of the polymerizable monomer (3-2) having a group containing a polyoxyalkylene chain and a (meth)acryloyl group as the polymerizable unsaturated group include "NK Ester M-20G", "NK Ester M-40G", "NK Ester M-90G", "NK Ester M-230G", "NK Ester AM-90G", "NK Ester AMP-10G", "NK Ester AMP-20G", and "NK Ester AMP-60G" manufactured by Shin-Nakamura Chemical Co., Ltd., "Blemmer PE-90", "Blemmer PE-200", "Blemmer PE-350", "Blemmer PME-100", "Blemmer PME-200", "Blemmer PME-400", "Blemmer PME-4000", "Blemmer PP-1000", "Blemmer PP-500", "Blemmer PP-800", "Blemmer 70PEP-350B", "Blemmer 55PET-800", "Blemmer 50POEP-800B", "Blemmer 10PPB-500B", "Blemmer NKH-5050", "Blemmer AP-400", and "Blemmer AE-350" manufactured by NOF Corporation, and the like.

The polymer of the present invention may be a polymer including the polymerizable monomer (1) and the polymerizable monomer (2) as polymerization components and the polymerization form thereof is not particularly limited.

The polymer of the present invention may be a random copolymer of the polymerizable monomer (1) and the polymerizable monomer (2) or may be a block copolymer of the polymerizable monomer (1) and the polymerizable monomer (2), and is preferably a block copolymer of the polymerizable monomer (1) and the polymerizable monomer (2).

When the polymer of the present invention is a block copolymer of the polymerizable monomer (1) and the polymerizable monomer (2), the numbers of the polymer blocks of the polymerizable monomer (1) and the polymer blocks of the polymerizable monomer (2) and the bonding order thereof are not particularly limited. For example, the polymer may be a diblock copolymer in which the polymer block of the polymerizable monomer (1) and the polymer block of the polymerizable monomer (2) are bonded to each other.

In the polymerization components, the polymerizable monomer (1) may be a single polymerizable monomer (1) or may contain two or more polymerizable monomers (1) having different structures.

Similarly, in the polymerization components, the polymerizable monomer (2) may be a single polymerizable monomer (2) or may contain two or more polymerizable monomers (2) having different structures.

In the polymerization components, the content ratio (polymerizable monomer (1)/total amount of polymerization components) of the polymerizable monomer (1) may be 20% by weight or less and is preferably 18% by mass or less, more preferably 15% by weight or less, and still more preferably 12% by weight or less. When the content ratio of the polymerizable monomer (1) in the polymerization components is within the range described above, the excellent leveling property can be obtained.

The lower limit of the content ratio of the polymerizable monomer (1) in the polymerization components is not particularly limited, but is, for example, 3% by weight or more, preferably 4% by weight or more, and more preferably 5% by weight or more.

The content ratio of the polymerizable monomer (1) can be adjusted by the raw material charging ratio of the polymerizable monomer (1) for producing the polymer of the present invention.

The mass ratio between the polymerizable monomer (1) and the polymerizable monomer (2) in the polymerization components is, for example, polymerizable monomer (1) : polymerizable monomer (2) = 3:97 to 20:80, preferably 5:95 to 15:85, and more preferably 5:95 to 12:88.

The content ratio (total mass of group represented by formula (A)/mass of silicone chain-containing polymer) of the group represented by the general formula (A) in the polymer of the present invention is, for example, 3% to 20% by mass, preferably 3% to 18% by mass, more preferably 5% to 15% by mass, and still more preferably 5% to 12% by mass, and particularly preferably 7% to 10% by mass.

The content ratio of the group represented by the general formula (A) can be adjusted by the raw material charging ratio of the polymerizable monomer (1) for producing the polymer of the present invention.

The polymerization components may contain the polymerizable monomer (1) and the polymerizable monomer (2), may substantially include the polymerizable monomer (1) and the polymerizable monomer (2), and may include only the polymerizable monomer (1) and the polymerizable monomer (2).

The "substantially include" represents that the total content ratio of the polymerizable monomer (1) and the polymerizable monomer (2) in the polymerization components is, for example, 80% by mass or more, 90% by mass or more, 95% by mass or more, or 98% by mass or more.

The polymer of the present invention preferably does not contain fluorine. The fluorine atom-free polymer can decrease accumulation in the environment and thus can decrease environmental load.

The polymer of the present invention preferably does not contain a reactive functional group.

In the present invention, the "reactive functional group" is a functional group which can react with another functional group to form a crosslinked structure or the like, and examples thereof include an isocyanate group, an epoxy group, a carboxyl group, a carboxylic acid halide group, a carboxylic anhydride group, or the like.

The weight-average molecular weight (Mw) of the polymer of the present invention is 15,000 or more, preferably 20,000 or more, and more preferably 20,500 or more.

The upper limit of the weight-average molecular weight (Mw) of the polymer of the present invention is not particularly limited, and is preferably, in order, 100,000 or less, 90,000 or less, 70,000 or less, and 50,000 or less.

The value of the weight-average molecular weight (Mw) of the polymer of the present invention is measured by a method described in examples.

### [Method for producing silicone chain-containing polymer]

The method for producing the polymer of the present invention is not particularly limited, and the polymer can be produced by a known method.

The polymer of the present invention can be produced by a solution polymerization method, a bulk polymerization method, an emulsion polymerization method, or the like using the polymerization components based on the polymerization mechanism of a radical polymerization method, a cationic polymerization method, an anionic polymerization method, or the like. For example, in the radical polymerization method, the polymer of the present invention can be produced by charging the polymerization components in an organic solvent and adding a general-purpose polymerization initiator.

The polymer produced by the method described above is a random copolymer.

Various polymerization initiators can be used as the polymerization initiator, and examples thereof include peroxides such as tert-butylperoxy-2-ethyl hexanoate, benzoyl peroxide, diacyl peroxide, and the like, azo compounds such as azobisisobutyronitrile, dimethyl azobisisobutyrate, phenyl azotriphenylmethane, and the like, metal chelate compounds such as Mn(acac)₃, and the like, and the like.

If required, a chain transfer agent such as lauryl mercaptan, 2-mercaptoethanol, ethyl thioglycolic acid, octyl thioglycolic acid, or the like, a chain transfer agent such as a thiol compound having a coupling group, such as γ-mercaptopropyl trimethoxysilane or the like, or the like may be used as an additive.

Examples of the organic solvent include alcohols such as ethanol, isopropyl alcohol, n-butanol, iso-butanol, tert-butanol, and the like, ketones such as acetone, methyl ethyl ketone, methyl isobutyl ketone, methyl amyl ketone, and the like, esters such as methyl acetate, ethyl acetate, butyl acetate, methyl lactate, ethyl lactate, butyl lactate, or the like, monocarboxylate esters such as methyl 2-oxypropionate, ethyl 2-oxypropionate, propyl 2-oxypropionate, butyl 2-oxypropionate, methyl 2-methoxypropionate, ethyl 2-methoxypropionate, propyl 2-methoxypropionate, butyl 2-methoxypropionate, and the like, polar solvents such as dimethylformamide, dimethyl sulfoxide, N-methyl pyrrolidone, and the like, ethers such as methyl cellosolve, cellosolve, butyl cellosolve, butyl carbitol, ethyl cellosolve acetate, and the like, propylene glycols and esters thereof, such as propylene glycol, propylene glycol monomethyl ether, propylene glycol monomethyl ether acetate, propylene glycol monoethyl ether acetate, propylene glycol monobutyl ether acetate, and the like, halogen-based solvents such as 1,1,1-trichloroethane, chloroform, and the like, ethers such as tetrahydrofuran, dioxane, and the like, aromatics such as benzene, toluene, xylene, and the like, fluorinated inert liquids such as perfluorooctane, perfluorotri-n-butylamine, and the like, and the like.

These solvents can be used alone or in combination of two or more.

The polymer of the present invention is preferably produced by starting the addition of the polymerizable monomer (1) to the reaction system, after starting the addition of the polymerizable monomer (1), adding the polymerizable monomer (2) and the polymerization initiator to the reaction system and starting polymerization, and finishing the addition of the polymerizable monomer (1) before the addition of the polymerizable monomer (2) and the polymerization initiator.

This is because when the polymer of the present invention is polymerized as described above, the unreacted silicone chain can be extremely decreased, and thus a concern about defects in a coating film due to additives can be suppressed during coating.

The polymerizable monomer (1) may contain a compound having a cyclic siloxane structure as an impurity, and thus the compound having a cyclic siloxane structure is preferably removed by distilling the polymerizable monomer (1) before addition to the reaction system, distilling the polymer after reaction, or the like. Distillation can be performed by a known method, but can be performed by, for example, thin-film distillation.

The polymer of the present invention can be produced by living polymerization, such as living radical polymerization, living anionic polymerization, or the like, of the polymerization components.

In the living radical polymerization, a dormant species having an active polymerization terminal protected by an atom or atom group reversibly generates radical and reacts with a monomer, and thus growth reaction proceeds. Even when a first monomer is consumed, the growth terminal does not lose reactivity and reacts with a sequentially added second monomer, thereby enabling to form a block polymer. Examples of the living radical polymerization include atom transfer radical polymerization (ATRP), reversible addition/fragmentation radical polymerization (RAFT), nitroxide-mediated radical polymerization (NMP), organotellurium-mediated radical polymerization (TERP), and the like. Which of these methods is used is not particularly limited, but ATRP is preferred because of the ease of control. ATRP is polymerization using an organic halide or sulfonyl halide compound as a polymerization initiator and a metal complex, containing a transition metal compound and a ligand, as a catalyst.

Specific examples of the polymerization initiator which can be used in ATRP include 1-phenylethyl chloride, 1-phenyl ethyl bromide, chloroform, carbon tetrachloride, 2-chloropropionitrile, α,α'-dichloroxylene, α,α'-dibromoxylene, hexakis(α-bromomethyl) benzene, alkyl esters (having 1 to 6 carbon atoms) of 2-halogenated carboxylic acids having 1 to 6 carbon atoms (for example, 2-chloropropionic acid, 2-bromopropionic acid, 2-chloroisobutyric acid, 2-bromoisobutyric acid, and the like), and the like.

More specific examples of alkyl esters (having 1 to 6 carbon atoms) of 2-halogenated carboxylic acids having 1 to 6 carbon atoms include methyl 2-chloropropionate, ethyl 2-chloropropionate, methyl 2-bromopropionate, ethyl 2-bromoisobutyrate, and the like.

The transition metal compound which can be used for ATRP is represented by Mⁿ⁺Xₙ.

The transition metal Mⁿ⁺ of the transition metal compound represented by Mⁿ⁺Xₙ can be selected from the group consisting of Cu⁺, Cu²⁺, Fe²⁺, Fe³⁺, Ru²⁺, Ru³⁺, Cr²⁺, Cr³⁺, Mo⁰, Mo⁺, Mo²⁺, Mo³⁺, W²⁺, W³⁺, Rh³⁺, Rh⁴⁺, Co⁺, Co²⁺, Re²⁺, Re³⁺, Ni°, Ni⁺, Mn³⁺, Mn⁴⁺, V²⁺, V³⁺, Zn⁺, Zn²⁺, Au⁺, Au²⁺, Ag⁺, and Ag²⁺.

X of the transition metal compound represented by Mⁿ⁺Xₙ can be selected from the group consisting of a halogen atom, an alkoxyl group having 1 to 6 carbon atoms, (SO₄)_{1/2}, (PO₄)_{1/3}, (HPO₄)_{1/2}, (H₂PO₄), triflate, hexafluorophosphate, methane sulfonate, aryl sulfonate (preferably, benzene sulfonate or toluene sulfonate), SeR¹¹, CN, and R¹²COO. Herein, R¹¹ represents an aryl group, or a linear or branched alkyl group having 1 to 20 carbon atoms (preferably 1 to 10 carbon atoms), and R¹² represents a hydrogen atom or a linear or branched alkyl group having 1 to 6 carbon atoms (preferably a methyl group) which may be substituted by halogen 1 to 5 times (preferably substituted by fluorine or chlorine 1 to 3 times).

n of the transition metal compound represented by Mⁿ⁺Xₙ represents the formal charge on a metal and is an integer of 0 to 7.

Examples of a ligand compound which can be coordinate-bonded to the transition metal of the transition metal compound include a compound having a ligand which can be coordinated to a transition metal through σ bond and contains one or more nitrogen atoms, oxygen atoms, phosphorus atoms, or sulfur atoms, a compound having a ligand which can be coordinated to a transition metal through π bond and contains two or more carbon atoms, and a compound having a ligand which can be coordinated to a transition metal through µ bond or η bond.

The transition metal complex is not particularly limited, but is preferably a complex of a group 7, 8, 9, 10, or 11 transition metal, and more preferably a complex of 0-valent copper, monovalent copper, divalent ruthenium, divalent iron, or divalent nickel.

Specific examples of the catalyst which can be used for ATRP, when the center metal is copper, include complexes with ligands such as 2,2'-bipyridyl and derivatives thereof, 1,10-phenanthroline and derivatives thereof, polyamines such as tetramethyl ethylenediamine, pentamethyl diethylene triamine, hexamethyl tris(2-aminoethyl)amine, and the like. Examples of a divalent ruthenium complex include dichlorotris(triphenylphosphine)ruthenium, dichlorotris(tributylphosphine)ruthenium,
dichloro(cyclooctadiene)ruthenium, dichlorobenzene ruthenium, dichloro-p-cymene ruthenium, dichloro(norbornadiene)ruthenium, cis-dichlorobis(2,2'-bipyridine)ruthenium, dichlorotris(1,10-phenanthroline)ruthenium, carbonyl chlorohydride tris(triphenylphosphine)ruthenium, and the like. Examples of a divalent iron complex include a bistriphenylphosphine complex, a triazacyclononane complex, and the like.

The living radial polymerization is preferably performed by using a solvent.

Examples of the solvent used in the living radical polymerization include ester-based solvents such as ethyl acetate, butyl acetate, propylene glycol monomethyl ether acetate, and the like; ether-based solvents such as diisopropyl ether, dimethoxyethane, diethylene glycol dimethyl ether, and the like; halogen-based solvents such as dichloromethane, dichloroethane, and the like; aromatic solvents such as toluene, xylene, and the like; ketone-based solvents such as methyl ethyl ketone, methyl isobutyl ketone, cyclohexanone, and the like; alcohol-based solvents such as methanol, ethanol, isopropanol, and the like; aprotic polar solvents such as dimethylformamide, dimethyl sulfoxide, and the like; and the like.

The solvents may be used alone or in combination of two or more.

When the polymer of the present invention is produced by living polymerization, the polymer can be produced by, for example, any one of methods 1 to 3 described above.

Method 1: A method including living radical polymerization (preferably atom transfer radical polymerization) of the polymerizable monomer (1) and the polymerizable monomer (2) in the presence of a polymerization initiator, a transition metal compound, a ligand compound which can be coordinate-bonded to the transition metal, and a solvent.

Method 2: A method including living radical polymerization (preferably atom transfer radical polymerization) of the polymerizable monomer (1) in the presence of a polymerization initiator, a transition metal compound, a ligand compound which can be coordinate-bonded to the transition metal, and a solvent to form a polymer block of the polymerizable monomer (1), and then adding the polymerizable monomer (2) to the reaction system and further living radical polymerization (preferably atom transfer radical polymerization) of the polymerizable monomer (2) with the polymer block of the polymerizable monomer (1).

Method 3: A method including living radical polymerization (preferably atom transfer radical polymerization) of the polymerizable monomer (2) in the presence of a polymerization initiator, a transition metal compound, a ligand compound which can be coordinate-bonded to the transition metal, and a solvent to form a polymer block of the polymerizable monomer (2), and then adding the polymerizable monomer (1) to the reaction system and further living radical polymerization (preferably atom transfer radical polymerization) of the polymerizable monomer (1) with the polymer block of the polymerizable monomer (2).

The polymerization temperature of the living radical polymerization is preferably within a range of room temperature to 120°C.

When the polymer of the present invention is produced by living radical polymerization, a metal derived from the transition metal compound used in polymerization may remain in the resultant polymer. The metal remaining in the resultant polymer may be removed by using active alumina or the like after the completion of polymerization.

### [Coating composition]

The polymer of the present invention can be preferably used as a leveling agent of a coating composition. The coating composition of the present invention contains the polymer of the present invention. The polymer of the present invention can be used as a fluorine atom-free leveling agent not containing fluorine atom, and thus the leveling agent has low accumulation in the environment and small environmental load.

The content of the polymer of the present invention contained in the coating composition of the present invention depends on the type of the base resin, the coating method, the intended film thickness, etc., but is preferably 0.0001 to 10 parts by mass, more preferably 0.001 to 5 parts by mass, and still more preferably 0.01 to 2 parts by mass relative to 100 parts by mass of the solid content (for example, the base resin) of the coating composition. When the content of the polymer of the present invention is within the range described above, the surface tension can be sufficiently decreased, the intended leveling property can be obtained, and the occurrence of a defect, such as foaming or the like, during coating can be suppressed.

Application of the coating composition of the present invention is not particularly limited, and the coating composition can be used in any application as long as the leveling property is required in the application. The coating composition of the present invention can be used as, for example, various coating compositions and photosensitive resin compositions.

When the coating composition of the present invention is used as a composition for a coating material, examples of the composition for a coating material include coating materials using natural resins, such as a petroleum resin coating material, a shellac coating material, a rosin-based coating material, a cellulose-based coating material, a rubber-based coating material, a lacquer coating material, a cashew resin coating material, an oily vehicle coating material, and the like; coating materials using synthetic resins, such as a phenol resin coating material, an alkyd resin coating material, an unsaturated polyester resin coating material, an amino resin coating material, an epoxy resin coating material, a vinyl resin coating material, an acrylic resin coating material, a polyurethane resin coating material, a silicone resin coating material, a fluorine resin coating material, and the like; and the like.

The addition of the polymer of the present invention to the composition for a coating material can impart smoothness to the resultant coating film.

If required, the following can be properly added to the composition for a coating material: a colorant such as a pigment, a dye, carbon, or the like; an inorganic powder such as silica, titanium oxide, zinc oxide, aluminum oxide, zirconium oxide, calcium oxide, calcium carbonate, or the like; an organic fine powder such as a higher fatty acid, a polyacrylic resin, polyethylene, or the like; and various additives such as a light-resistant improver, a weather-resistant improver, a heat-resistant improver, an antioxidant, a thickener, an anti-settling agent, and the like.

Any coating method can be used as a coating method for the coating composition of the present invention as long as it is a known usual method, and examples thereof include methods such as a slit coater, a slit & spin coater, a spin coater, a roll coater, electrostatic coating, a bar coater, a gravure coater, a die coater, a knife coater, ink jet, dipping coating, spray coating, shower coating, screen printing, gravure printing, offset printing, reverse coating, and the like.

The photosensitive resin composition is a composition in which the physical properties of the resin, such as solubility, viscosity, transparency, refractive index, conductivity, ion permeability, etc., are changed by irradiation with light such as visible light, ultraviolet light, or the like.

Among the photosensitive resin compositions, a resist composition (a photoresist composition, a color resist composition for a color filter, or the like) is required to have a high degree of leveling property. The resist composition is generally coated on a silicon wafer or a glass substrate, on which various metals are vapor-deposited, by spin coating so that the thickness is about 1 to 2 µm. In this case, fluctuation in thickness of the coating film or the occurrence of coating unevenness decreases pattern linearity and reproductivity and thus causes the problem of failing to obtain a resist pattern having intended precision. Also, besides this problem, there are various problems with leveling, such as dropping marks, overall unevenness, a bead phenomenon in which an edge portion is thickened compared with a central portion, etc.

The problems can be solved when the coating composition of the present invention is used as a resist composition because the polymer of the present invention can exhibit a high degree of leveling property and can form a uniform coating film (cured product).

When the coating composition of the present invention is used as a photoresist composition, the photoresist composition contains, other than the polymer of the present invention, an alkali-soluble resin, a radiation-sensitive material (photosensitive material), a solvent, etc.

The alkali-soluble resin contained in the photoresist composition is a resin soluble in an alkaline solution used as a developing solution used for resist patterning.

Examples of the alkali-soluble resin include a novolac resin obtained by condensation of an aromatic hydroxyl compound derivative such as phenol, cresol, xylenol, resorcinol, fluoroglycinol, hydroquinone, or the like with an aldehyde compound such as formaldehyde, acetaldehyde, benzaldehyde, or the like; a polymer or copolymer of a vinyl phenol compound derivative such as o-vinyl phenol, m-vinyl phenol, p-vinyl phenol, α-methyl vinyl phenol, or the like; a polymer or copolymer of a (meth)acrylic acid compound such as acrylic acid, methacrylic acid, hydroxymethyl
(meth)acrylate, or the like; polyvinyl alcohol; a modified resin in which a radiation-sensitive group, such as a quinonediazide group, a naphthoquinonediazide group, an aromatic diazide group, an aromatic cinnamoyl group, or the like, is introduced through some of the hydroxyl groups of any one of these resins; a urethane resin containing an acid group such as a carboxylic acid, sulfonic acid, or the like

### in the molecule thereof; and the like.

These alkali-soluble resins may be used alone or in combination of two or more.

The radiation-sensitive material contained in the photoresist composition is a material which changes the solubility of the alkali-soluble resin in the developing solution by irradiation with active energy rays such as ultraviolet light, far-ultraviolet light, excimer laser, X-rays, electron beams, ion beams, molecular beams, γ-rays, or the like.

Examples of the radiation-sensitive material include a quinonediazide-based compound, a diazo-based compound, an azide-based compound, an onium salt compound, a halogenated organic compound, a mixture of a halogenated organic compound and an organic metal compound, an organic acid ester compound, an organic acid amide compound, an organic acid imide compound, a poly(olefin sulfone)compound, and the like.

Examples of the quinonediazide-based compound include 1,2-benzoquinoneazide-4-sulfonate ester, 1,2-naphthoquinonediazide-4-sulfonate ester, 1,2-naphthoquinonediazide-5-sulfonate ester, 2,1-naphthoquinonediazide-4-sulfonate ester, 2,1-naphthoquinonediazide-5-sulfonate ester, quinonediazide derivative sulfonic acid chlorides such as 1,2-benzoquinoneazide-4-sulfonic acid chloride, 1,2-naphthoquinonediazide-4-sulfonic acid chloride, 1,2-naphthoquinonediazide-5-sulfonic acid chloride, 2,1-naphthoquinonediazide-4-sulfonic acid chloride, 2,1-naphthoquinonediazide-5-sulfonic acid chloride, and the like.

Examples of the diazo-based compound include a salt of condensate of p-diazodiphenylamine and formaldehyde or acetaldehyde, a diazo resin inorganic salt which is the reaction product of a hexafluorophosphate salt, a tetrafluoroborate salt, a perchlorate salt, or a periodate salt with the condensate, a diazo resin organic salt which is the reaction products of the condensate with sulfonic acids as described in the specifications of USP Nos. 3, 300, and 309, and the like.

Examples of the azide-based compound include azidochalconic acid, diazidobenzal methyl cyclohexanones, azidocinnamylidene acetophenones, aromatic azide compounds, aromatic diazide compounds, and the like.

Examples of the halogenated organic compound include a halogen-containing oxadiazole-based compound, a halogen-containing triazine-based compound, a halogen-containing acetophenone-based compound, a halogen-containing benzophenone-based compound, a halogen-containing sulfoxide-based compound, a halogen-containing sulfone-based compound, a halogen-containing thiazole-based compound, a halogen-containing oxazole-based compound, a halogen-containing triazole-based compound, a halogen-containing 2-pyrone-based compound, a halogen-containing aliphatic hydrocarbon-based compound, a halogen-containing aromatic hydrocarbon-based compound, a halogen-containing heterocyclic compound, a sulfenyl halide-based compound, and the like.

Besides the above, examples of the halogenated organic compound include compounds used as halogen-based flame retardants, such as tris(2,3-dibromopropyl) phosphate, tris(2,3-dibromo-3-chloropropyl) phosphate, chlorotetrabromomethane, hexachlorobenzene, hexabromobenzene, hexabromocyclododecane, hexabromobiphenyl, tribromophenyl allyl ether, tetrachlorobisphenol A, tetrabromobisphenol A, bis(bromoethyl ether) tetrabromobisphenol A, bis(chloroethyl ether) tetrachlorobisphenol A, tris(2,3-dibromopropyl) isocyanurate, 2,2-bis(4-hydroxy-3,5-dibromophenyl) propane, 2,2-bis(4-hydroxyethoxy-3,5-dibromophenyl) propane, and the like, compounds used as organic chloro-based agricultural chemicals, such as dichlorophenyl trichloroethane, and the like, and the like.

Examples of the organic acid ester include a carboxylate ester, a sulfonate ester, and the like. Examples of the organic acid amide include carboxylic acid amide, sulfonic acid amide, and the like. Examples of the organic acid imide include carboxylic acid imide, sulfonic acid imide, and the like.

The radiation-sensitive materials may be used alone or in combination of two or more.

The content of the radiation-sensitive material in the photoresist composition is preferably within a range of 10 to 200 parts by mass and more preferably within a range of 50 to 150 parts by mass relative to 100 parts by mass of the alkali-soluble resin.

Examples of the solvent for the photoresist composition include ketones such as acetone, methyl ethyl ketone, cyclohexanone, cyclopentanone, cycloheptanone, 2-heptanone, methyl isobutyl ketone, butyrolactone, and the like, alcohols such as methanol, ethanol, n-propyl alcohol, isopropyl alcohol, n-butyl alcohol, iso-butyl alcohol, tert-butyl alcohol, pentanol, heptanol, octanol, nonanol, decanol, and the like; ethers such as ethylene glycol dimethyl ether, ethylene glycol diethyl ether, dioxane, and the like; alcohol ethers such as ethylene glycol monomethyl ether, ethylene glycol monoethyl ether, ethylene glycol monopropyl ether, propylene glycol monomethyl ether, propylene glycol monoethyl ether, propylene glycol monopropyl ether, and the like; esters such as ethyl formate, propyl formate, butyl formate, methyl acetate, ethyl acetate, butyl acetate, propyl acetate, methyl propionate, ethyl propionate, propyl propionate, butyl propionate, methyl butyrate, ethyl butyrate, butyl butyrate, propyl butyrate, ethyl lactate, butyl lactate, and the like, monocarboxylate esters such as methyl 2-oxypropionate, ethyl 2-oxypropionate, propyl 2-oxypropionate, butyl 2-oxypropionate, methyl 2-methoxypropionate, ethyl 2-methoxypropionate, propyl 2-methoxypropionate, butyl 2-methoxypropionate, and the like; cellosolve esters such as cellosolve acetate, methyl cellosolve acetate, ethyl cellosolve acetate, propyl cellosolve acetate, butyl cellosolve acetate, and the like; propylene glycols such as propylene glycol, propylene glycol monomethyl ether, propylene glycol monomethyl ether acetate, propylene glycol monoethyl ether acetate, propylene glycol monobutyl ether acetate, and the like; diethylene glycols such as diethylene glycol monomethyl ether, diethylene glycol monoethyl ether, diethylene glycol dimethyl ether, diethylene glycol diethyl ether, diethylene glycol methyl ethyl ether, and the like; halogenated hydrocarbons such as trichloroethylene, a freon solvent, HCFC, HFC, and the like; completely fluorinated solvents such as perfluorooctane and the like, aromatics such as toluene, xylene, and the like; polar solvents such as dimethyl acetyamide, dimethyl formamide, N-methyl acetamide, N-methyl pyrrolidone, and the like.

These solvents may be used alone or in combination of two or more.

When the coating composition of the present invention is used as a color resist composition, the color resist composition contains, other than the polymer of the present invention, an alkali-soluble resin, a polymerizable compound, a coloring agent, etc.

Usable examples of the alkali-soluble resin contained in the color resist include the same as the examples of the alkali-soluble resin contained in the photoresist composition described above.

The polymerizable compound contained in the color resist composition is a compound having a photopolymerizable functional group capable of polymerization or crosslinking reaction by, for example, irradiation with active energy rays such as ultraviolet light or the like.

Examples of the polymerizable compound include unsaturated carboxylic acids such as (meth)acrylic acid and the like, esters of monohydroxy compounds and unsaturated carboxylic acids, esters of aliphatic polyhydroxy compounds and unsaturated carboxylic acids, esters of aromatic polyhydroxy compounds and unsaturated carboxylic acids, esters obtained by esterification reaction of unsaturated carboxylic acids, polyvalent carboxylic acids, and polyvalent hydroxy compounds such as the aliphatic polyhydroxy compounds, the aromatic polyhydroxy compounds, or the like, a polymerizable compound having a urethane skeleton obtained by reaction of a polyisocyanate compound and a (meth)acryloyl group-containing hydroxy compound, a polymerizable compound having an acid group, and the like.

The polymerizable compounds may be used alone or in combination of two or more.

Examples of the esters of aliphatic polyhydroxy compounds and unsaturated carboxylic acids include (meth)acrylate esters such as ethylene glycol di(meth)acrylate, triethylene glycol di(meth)acrylate, trimethylolpropane tri(meth)acrylate, trimethylolethane tri(meth)acrylate, pentaerythritol di(meth)acrylate, pentaerythritol tri(meth)acrylate, pentaerythritol tetra(meth)acrylate, dipentaerythritol tetra(meth)acrylate, dipentaerythritol penta(meth)acrylate, dipentaerythritol hexa(meth)acrylate, glycerol (meth)acrylate, and the like.

The examples also include itaconate esters, crotonate esters, and maleate esters, which are produced by substituting the (meth)acrylic acid portions of these acrylates with itaconic acid, crotonic acid, and maleic acid, respectively, and the like.

Examples of the esters of aromatic polyhydroxy compounds and unsaturated carboxylic acids include hydroquinone di(meth)acrylate, resorcine di(meth)acrylate, pyrogallol tri(meth)acrylate, and the like.

The ester obtained by esterification reaction of an unsaturated carboxylic acid, a polyvalent carboxylic acid, and a polyvalent hydroxy compound may be a single material or a mixture. Examples of the ester include an ester obtained from (meth)acrylic acid, phthalic acid, and ethylene glycol, an ester obtained by (meth)acrylic acid, maleic acid, and diethylene glycol, an ester obtained from (meth)acrylic acid, terephthalic acid, and pentaerythritol, an ester obtained from (meth)acrylic acid, adipic acid, butanediol, and glycerin, and the like.

Examples of the polymerizable compound having a urethane skeleton and produced by reaction of a polyisocyanate and a (meth)acryloyl group-containing hydroxy compound include the reaction product of aliphatic diisocyanate such as hexamethylene diisocyanate, trimethylhexamethylene diisocyanate, or the like; alicyclic diisocyanate such as cyclohexane diisocyanate, isophorone diisocyanate, or the like; or aromatic diisocyanate such as tolylene diisocyanate, diphenylmethane diisocyanate, or the like, and a hydroxy compound having a (meth)acryloyl group such as 2-hydroxyethyl (meth)acrylate, 3-hydroxy[1,1,1-tri(meth)acryloyloxymethyl] propane, or the like.

The polymerizable compound having an acid group is, for example, an ester of an aliphatic polyhydroxy compound and an unsaturated carboxylic acid, and is preferably a polyfunctional polymerizable compound imparted with an acid group by reacting an unreacted hydroxyl group of an aliphatic polyhydroxy compound with nonaromatic carboxylic anhydride. The aliphatic polyhydroxy compound used for preparing the polyfunctional polymerizable compound is preferably pentaerythritol or dipentaerythritol.

Because developability, curability, etc. are improved, the acid value of the polyfunctional polymerizable compound is preferably within a range of 0.1 to 40 and more preferably within a range of 5 to 30. When two or more polyfunctional polymerizable compounds having an acid group are used in combination and when a polyfunctional polymerizable compound having an acid group and a polyfunctional polymerizable compound not having an acid group are used in combination, the acid value of the mixture of the polyfunctional polymerizable compounds is preferably adjusted to fall within the range described above.

Examples of the polymerizable compound having an acid group include dipentaerythritol hexaacrylate, and a mixture of dipentaerythritol pentaacrylate and dipentaerythritol pentaacrylate succinate ester as main components, and the mixture is commercially available as Aronix TO-1382 (manufactured by Toagosei Co., Ltd.).

Examples of the polymerizable compound other than the above compounds include (meth)acrylamide such as ethylene bis(meth)acrylamide and the like; allyl esters such as diallyl phthalate and the like; compounds having a vinyl group such as divinyl phthalate and the like; and the like.

The content of the polymerizable compound in the color resist composition is preferably within a range of 5% to 80% by mass, more preferably within a range of 10% to 70% by mass, and still more preferably within a range of 20% to 50% by mass, in the total solid content of the color resist composition.

The coloring agent of the color resist composition is not particularly limited as long as it is capable of coloring, and it may be, for example, a pigment or a dye.

Any one of an organic pigment and an inorganic pigment can be used as the pigment. Usable examples of the organic pigment include pigments of respective hues, such as a red pigment, a green pigment, a blue pigment, a yellow pigment, a violet pigment, an orange pigment, a brown pigment, and the like. Also, examples of the chemical structure of the organic pigment include an azo type, a phthalocyanine type, a quinacridone type, a benzimidazolone type, an isoindolinone type, a dioxazine type, an indanthrene type, a perylene type, and the like. Examples of the inorganic pigment include barium sulfate, lead sulfate, titanium oxide, yellow lead, bengala, chromium oxide, and the like.

In addition, "C. I." described below represents Color Index.

Examples of the red pigment include C. I. Pigment Red 1, 2, 3, 4, 5, 6, 7, 8, 9, 12, 14, 15, 16, 17, 21, 22, 23, 31, 32, 37, 38, 41, 47, 48, 48:1, 48:2, 48:3, 48:4, 49, 49:1, 49:2, 50:1, 52:1, 52:2, 53, 53:1, 53:2, 53:3, 57, 57:1, 57:2, 58:4, 60, 63, 63:1, 63:2, 64, 64:1, 68, 69, 81, 81:1, 81:2, 81:3, 81:4, 83, 88, 90:1, 101, 101:1, 104, 108, 108:1, 109, 112, 113, 114, 122, 123, 144, 146, 147, 149, 151, 166, 168, 169, 170, 172, 173, 174, 175, 176, 177, 178, 179, 181, 184, 185, 187, 188, 190, 193, 194, 200, 202, 206, 207, 208, 209, 210, 214, 216, 220, 221, 224, 230, 231, 232, 233, 235, 236, 237, 238, 239, 242, 243, 245, 247, 249, 250, 251, 253, 254, 255, 256, 257, 258, 259, 260, 262, 263, 264, 265, 266, 267, 268, 269, 270, 271, 272, 273, 274, 275, 276, and the like. Among these, C. I. Pigment Red 48:1, 122, 168, 177, 202, 206, 207, 209, 224, 242, or 254 is preferred, and C. I. Pigment Red 177, 209, 224, or 254 is more preferred.

Examples of the green pigment include C. I. Pigment Green 1, 2, 4, 7, 8, 10, 13, 14, 15, 17, 18, 19, 26, 36, 45, 48, 50, 51, 54, 55, 58, and the like. Among these, C. I. Pigment Green 7, 36, or 58 is preferred.

Examples of the blue pigment include C. I. Pigment Blue 1, 1:2, 9, 14, 15, 15:1, 15:2, 15:3, 15:4, 15:6, 16, 17, 19, 25, 27, 28, 29, 33, 35, 36, 56, 56:1, 60, 61, 61:1, 62, 63, 66, 67, 68, 71, 72, 73, 74, 75, 76, 78, 79, and the like. Among these, C. I. Pigment Blue 15, 15:1, 15:2, 15:3, 15:4, or 15:6 is preferred, and C. I. Pigment Blue 15:6 is more preferred.

Examples of the yellow pigment include C. I. Pigment Yellow 1, 1:1, 2, 3, 4, 5, 6, 9, 10, 12, 13, 14, 16, 17, 24, 31, 32, 34, 35, 35:1, 36, 36:1, 37, 37:1, 40, 41, 42, 43, 48, 53, 55, 61, 62, 62:1, 63, 65, 73, 74, 75,81, 83, 87, 93, 94, 95, 97, 100, 101, 104, 105, 108, 109, 110, 111, 116, 117, 119, 120, 126, 127, 127:1, 128, 129, 133, 134, 136, 138, 139, 142, 147, 148, 150, 151, 153, 154, 155, 157, 158, 159, 160, 161, 162, 163, 164, 165, 166, 167, 168, 169, 170, 172, 173, 174, 175, 176, 180, 181, 182, 183, 184, 185, 188, 189, 190, 191, 191:1, 192, 193, 194, 195, 196, 197, 198, 199, 200, 202, 203, 204, 205, 206, 207, 208, and the like. Among these, C. I. Pigment Yellow 83, 117, 129, 138, 139, 150, 154, 155, 180, or 185 is preferred, and C. I. Pigment Yellow 83, 138, 139, 150, or 180 is more preferred.

Examples of the violet pigment include C. I. Pigment Violet 1, 1:1, 2, 2:2, 3, 3:1, 3:3, 5, 5:1, 14, 15, 16, 19, 23, 25, 27, 29, 31, 32, 37, 39, 42, 44, 47, 49, 50, and the like. Among these, C. I. Pigment Violet 19 or 23 is preferred, and C. I. Pigment Violet 23 is more preferred.

Examples of the orange pigment include C. I. Pigment Orange 1, 2, 5, 13, 16, 17, 19, 20, 21, 22, 23, 24, 34, 36, 38, 39, 43, 46, 48, 49, 61, 62, 64, 65, 67, 68, 69, 70, 71, 72, 73, 74, 75, 77, 78, 79, and the like. Among these, C. I. Pigment Orange 38 or 71 is preferred.

The pixels of the three primary colors of a color filter used in a liquid crystal display device and an organic EL display device are red (R), green (G), and blue (B), and thus the red pigment, the green pigment, and the blue pigment are used main components. In addition, an organic pigment of a color such as yellow, violet, orange, or the like may be used for hue adjustment for the purpose of improving color reproducibility.

In order to enhance brightness of a color liquid crystal display device and an organic EL display device, the average particle diameter of the organic pigment is preferably 1 µm or less, more preferably 0.5 µm or less, and still more preferably 0.3 µm or less. The organic pigment is preferably dispersed and then used so as to have the average particle diameter described above.

The average primary particle diameter of the organic pigment is preferably 100 nm or less, more preferably 50 nm or less, still more preferably 40 nm or less, and particularly preferably within a range of 10 to 30 nm.

The average particle diameter of the organic pigment is measured by a dynamic light scattering particle size distribution analyzer, and can be measured by, for example, Nanotrac particle size distribution measuring device "UPA-EX150", "UPA-EX250", or the like manufactured by Nikkiso Co., Ltd.

When the color resist composition is used for forming a black matrix (BM), the coloring agent is not particularly limited as long as it is black, and examples thereof include carbon black, lamp black, acetylene black, bone black, thermal black, channel black, furnace black, graphite, iron black, titanium black, and the like. Among these, carbon black and titanium black are preferred from the viewpoint of light shielding rate and image characteristics.

Also, two or more organic pigments may be used in combination as a mixture to form a mixed black color.

Examples of a commercial product of the carbon black include MA7, MA8, MA11, MA100, MA100R, MA220, MA230, MA600, #5, #10, #20, #25, #30, #32, #33, #40, #44, #45, #47, #50, #52, #55, #650, #750, #850, #950, #960, #970, #980, #990, #1000, #2200, #2300, #2350, #2400, #2600, #3050, #3150, #3250, #3600, #3750, #3950, #4000, #4010, OIL 7B, OIL 9B, OIL 11B, OIL 30B, OIL 31B, and the like, which are manufactured by Mitsubishi Chemical Corporation, Printex 3, Printex 30P, Printex 30, Printex 300P, Printex 40, Printex 45, Printex 55, Printex 60, Printex 75, Printex 80, Printex 85, Printex 90, Printex A, Printex L, Printex G, Printex P, Printex U, Printex V, Printex G, Special Black 550, Special Black 350, Special Black 250, Special Black 100, Special Black 6, Special Black 5, Special Black 4, Color Black FW1, Color Black FW2, Color Black FW2V, Color Black FW18, Color Black FW18, Color Black FW200, Color Black S160, Color Black S170, and the like, which are manufactured by Evonik Degussa Japan Co., Ltd., Monarch 120, Monarch 280, Monarch 460, Monarch 800, Monarch 880, Monarch 900, Monarch 1000, Monarch 1100, Monarch 1300, Monarch 1400, Monarch 4630, REGAL 99, REGAL 99R, REGAL 415, REGAL 415R, REGAL 250, REGAL 250R, REGAL 330, REGAL 400R, REGAL 55R0, REGAL 660R, BLACK PEARLS 480, PEARLS 130, VULCAN XC72R, ELFTEX-8, and the like, which are manufactured by Cabot Corporation, and RAVEN 11, RAVEN 14, RAVEN 15, RAVEN 16, RAVEN 22, RAVEN 30, RAVEN 35, RAVEN 40, RAVEN 410, RAVEN 420, RAVEN 450, RAVEN 500, RAVEN 780, RAVEN 850, RAVEN 890H, RAVEN 1000, RAVEN 1020, RAVEN 1040, RAVEN 1060U, RAVEN 1080U, RAVEN 1170, RAVEN 1190U, RAVEN 1250, RAVEN 1500, RAVEN 2000, RAVEN 2500U, RAVEN 3500, RAVEN 5000, RAVEN 5250, RAVEN 5750, RAVEN 7000, and the like, which are manufactured by Colombian Carbon Co., Ltd.

Among the carbon black described above, carbon black coated with a resin is preferred as having a high optical density and high surface resistivity required for the black matrix of the color filter.

Examples of a commercial product of the titanium black include Titanium Black 10S, 12S, 13R, 13M, 13M-C, and the like which are manufactured by Mitsubishi Materials Corporation.

A coloring agent used for forming the black matrix (BM) may be black formed as a mixed color by mixing two or more organic pigments, and is, for example, a black pigment prepared by mixing the three-color pigments of red, green, and blue. Examples of a color material which can be used and mixed for preparing a black pigment include Victoria Pure Blue (C. I. 42595), Auramine O (C. I. 41000), Cathilon Brilliant flavin (Basic 13), Rhodamine 6GCP (C. I. 45160), Rhodamine B (C. I. 45170), Safranine OK70:100 (C. I. 50240), Erioglaucin X (C. I. 42080), No.120/Lionol Yellow (C. I. 21090), Lionol Yellow GRO (C. I. 21090), Symuler Fast Yellow 8GF (C. I. 21105), Benzidine Yellow 4T-564D (C. I. 21095), Symuler Fast Red 4015 (C. I. 12355), Lionol Red 7B4401 (C. I. 15850), Fastogen Blue TGR-L (C. I. 74160), Lionol Blue SM (C. I. 26150), Lionol Blue ES (C. I. Pigment Bleu-15:6), Lionogen Red GD (C. I. Pigment Red 168), Lionol Green 2YS (C. I. Pigment Green 36), and the like.

Examples of other color materials which can be used and mixed for preparing a black pigment include C. I. Yellow Pigment 20, 24, 86, 93, 109, 110, 117, 125, 137, 138, 147, 148, 153, 154, and 166, C. I. Orange Pigment 36, 43, 51, 55, 59, and 61, C. I. Red Pigment 9, 97, 122, 123, 149, 168, 177, 180, 192, 215, 216, 217, 220, 223, 224, 226, 227, 228, and 240, C. I. Violet Pigment1 19, 23, 29, 30, 37, 40, and 50, C. I. Blue Pigment 15, 15:1, 15:4, 22, 60, and 64, C. I. Green Pigment 7, C. I. Brown Pigment 23, 25, and 26, and the like.

When carbon black is used as a black pigment, the average primary particle diameter of carbon black is preferably within a range of 0.01 to 0.08 µm, and because of good developability, the diameter is more preferably within a range of 0.02 to 0.05 µm.

Unlike the particle shape of an organic pigment or the like, the carbon black is present in a state called "structure" in which primary particles are fused to each other, and fine pores may be formed in the particle surfaces by post treatment. Therefore, in order to indicate the particle shape of carbon black, besides the average particle diameter of primary particles determined by the same method as for the organic pigment, the DBP absorption amount (JIS K6221) and the specific surface area according to the BET method (JIS K6217) are preferably measured as indexes of the structure and pore amount.

The dibutyl phthalic acid (abbreviated as "DBP" hereinafter) absorption amount of carbon black is preferably within a range of 40 to 100 cm³/100 g, and because of good dispersibility and developability, it is more preferably within a range of 50 to 80 cm³/100 g. The specific surface area of carbon black according to the BET method is preferably within a range of 50 to 120 m²/g, and because of good dispersion stability, it is more preferably within a range of 60 to 95 m²/g.

Examples of a dye serving as the coloring agent for the color resist composition include an azo-based dye, an anthraquinone-based dye, a phthalocyanine-based dye, a quinoneimine-based dye, a quinoline-based dye, a nitro-based dye, a carbonyl-based dye, a methine-based dye, and the like.

Examples of the azo-based dye include C. I. Acid Yellow 11, C. I. Acid Orange 7, C. I. Acid Red 37, C. I. Acid Red 180, C. I. Acid Blue 29, C. I. Direct Red 28, C. I. Direct Red 83, C. I. Direct Yellow 12, C. I. Direct Orange 26, C. I. Direct Green 28, C. I. Direct Green 59, C. I. Reactive Yellow 2, C. I. Reactive Red 17, C. I. Reactive Red 120, C. I. Reactive Black 5, C. I. Disperse Orange 5, C. I. Disperse Red 58, C. I. Disperse Blue 165, C. I. Basic Blue 41, C. I. Basic Red 18, C. I. Mordant Red 7, C. I. Mordant Yellow 5, C. I. Mordant Black 7, and the like.

Examples of the anthraquinone-based dye include C. I. Vat Blue 4, C. I. Acid Blue 40, C. I. Acid Green 25, C. I. Reactive Blue 19, C. I. Reactive Blue 49, C. I. Disperse Red 60, C. I. Disperse Blue 56, C. I. Disperse Blue 60, and the like.

Examples of the phthalocyanine-based dye include C. I. Vat Blue 5 and the like, examples of the quinoneimine-based dye include C. I. Basic Blue 3, C. I. Basic Blue 9, and the like, examples of the quinoline-based dye include C. I. Solvent Yellow 33, C. I. Acid Yellow 3, C. I. Disperse Yellow 64, and the like, and examples of the nitro-based dye include C. I. Acid Yellow 1, C. I. Acid Orange 3, C. I. Disperse Yellow 42, and the like.

In view of the excellent light resistance, weather resistance, and fastness of the resultant coating film, a pigment is preferably used as the coloring agent of the color resist composition, but if required, a dye may be used in combination with a pigment for adjusting hue.

The content of the coloring agent in the color resist composition is preferably 1% by mass or more, more preferably within a range of 5% to 80% by mass, and still more preferably within a range of 5% to 70% by mass in the total solid content of the color resist composition.

When the color resist composition is used for forming pixels of each of red (R), green (G), and blue (B) in a color filter, the content of the coloring agent in the color resist composition is preferably within a range of 5% to 60% by mass and more preferably within a range of 10% to 50% by mass in the total solid content of the color resist composition.

When the color resist composition is used for forming the black matrix of a color filter, the content of the coloring agent in the color resist composition is preferably within a range of 20% to 80% by mass and more preferably within a range of 30% to 70% by mass in the total solid content of the color resist composition.

When the coloring agent in the color resist composition is the pigment, a dispersion liquid prepared by dispersing the pigment in an organic solvent using a dispersant is preferably used.

Examples of the dispersant include a surfactant; a pigment intermediate or derivative; a dye intermediate or derivative; resin-type dispersants such as a polyamide-based resin, a polyurethane-based resin, a polyester-based resin, an acrylic resin, and the like; and the like. Among these, a nitrogen atom-containing graft copolymer, a nitrogen atom-containing acrylic block copolymer, a urethane resin dispersant, and the like are preferred. These dispersants have a nitrogen atom and thus the nitrogen atom has affinity for the pigment surfaces, while the portion other than the nitrogen atom enhances affinity for the medium, thereby improving dispersion stability.

These dispersants may be used alone or in combination of two or more.

Examples of a commercial product of the dispersant include "Efka" series ("Efka 46" and the like) manufactured by BASF Corporation; "Disper byk" series and "BYK" series ("BYK-160", "BYK-161", "BYK-2001", and the like) manufactured by BYK Chemie Japan KK; "Solsperse" series manufactured by Lubrizol Corporation; "KP" series manufactured by Shin-Etsu Chemical Co., Ltd., "Polyflow" series manufactured by Kyoseisha Chemical Co., Ltd.; "Disparlon" series manufactured by Kusumoto Chemicals, Ltd.; "Ajisper" series ("Ajisper PB-814" and the like) manufactured by Ajinomoto Fine-Techno Co., Inc., and the like.

Examples of the organic solvent used for preparing the pigment dispersion liquid include acetate ester-based solvents such as propylene glycol monomethyl ether acetate, propylene glycol monoethyl ether acetate, and the like; propionate-based solvents such as ethoxy propionate and the like; aromatic solvents such as toluene, xylene, methoxybenzene, and the like; ether-based solvents such as butyl cellosolve, propylene glycol monomethyl ether, diethylene glycol ethyl ether, diethylene glycol dimethyl ether, and the like; ketone-based solvents such as methyl ethyl ketone, methyl isobutyl ketone, cyclohexanone, and the like; aliphatic hydrocarbon-based solvents such as hexane and the like; nitrogen compound-based solvents such as N,N-dimethyl formamide, γ-butyrolactam, N-methyl-2-pydrrolidone, and the like; lactone-based solvents such as γ-butyrolactone and the like; carbamate esters; and the like.

These solvents may be used alone or in combination of two or more.

Examples of a method for preparing the pigment dispersion liquid include a method including a coloring agent kneading-dispersing step and a fine dispersing step, a method including only a fine dispersing step, and the like. In the kneading-dispersing step, the coloring agent, a portion of the alkali-soluble resin, and, if required, the dispersant are mixed and kneaded. The coloring agent can be dispersed by dispersion using a kneader while applying a strong shear force.

Examples of a machine used for kneading include a two-roll mill, a three-roll mill, a ball mill, a Tron mill, Disper, a kneader, a co-kneader, a homogenizer, a blender, a single-screw or twin-screw extruder, and the like.

Before the kneading, the particle size of the coloring agent is preferably miniaturized by salt milling method or the like.

In the fine dispersing step, a mixture prepared by adding a solvent to a composition containing the coloring agent and obtained by the kneading and dispersing step or a mixture containing the coloring agent, the alkali-soluble resin, the solvent, and, if required, the dispersant is mixed and dispersed by using a disperser together with a fine particle medium for dispersion, such as glass, zirconia, or ceramic. In this step, the particles of the coloring agent can be dispersed to a fine state close to the primary particles.

From the viewpoint of improving the transmittance, contrast, etc. of the color filter, the average particle diameter of the primary particles of the coloring agent is preferably 10 to 100 nm and more preferably 10 to 60 nm. The average particle diameter of the coloring agent is measured by a dynamic light scattering particle size distribution analyzer, and can be measured by, for example, Nanotrac particle size distribution measuring device "UPA-EX150", "UPA-EX250", or the like manufactured by Nikkiso Co., Ltd.

The composition for a coating material, the photoresist composition, and the color resist composition are exemplified above as the coating composition, but the coating composition is not limited to these.

Examples of application of the coating composition of the present invention include an anti-glare (AG: anti-glare) hard coating material, an antireflection (LR) coating material, a low-refractive-index layer coating material, a high-refractive-index layer coating material, a clear hard coating material, and a polymerizable liquid crystal coating material, which are coating materials for various display screens, such as a liquid crystal display (abbreviated as "LCD" hereinafter), a plasma display (abbreviated as "PDP" hereinafter), an organic EL display (abbreviated as "OLED" hereinafter), a quantum dot display (abbreviated as "QDD" hereinafter), and the like; a color resist, an ink jet ink, a printing in, or a coating material for forming pixels of each of RGB and the like of a color filter (abbreviated as "CF" hereinafter) of LCD or the like; a black resist, an ink jet ink, a printing ink, or a coating material for forming a black matrix, a black column spacer, and a black photo-spacer of CF of LCD or the like; a coating material for a transparent protective film for protecting the CF surface used in CF of LCD or the like; a liquid crystal material, a column spacer, and a resin composition for a photo-spacer of LCD; a resin composition for pixel partitions, a positive photoresist for forming electrodes, a protective film, an insulating film, a plastic casing, a coating material for a plastic casing and a bezel (frame) ink of LCD, PDP, OLED, QDD, or the like; a prism sheet as a backlight member, and a light diffusion film of LCD; a coating material for an organic insulating film of a liquid crystal TFT array of LCD; an internal polarizing plate surface protection coating material of LCD; a phosphor of PDP; an organic EL material and a sealing material (a protective film or a gas barrier) of OLED; a quantum dot ink, a sealing material, and a protective film of QDD; a high-refractive-index lens, a low-refractive-index seal, and LED pixels of a micro (mini) LED display; a positive photoresist, a chemical amplification type photoresist, an antireflection film, a multilayer material (SOC, SOG), a lower layer film, a buffer coat, a developer, a rinsing liquid, a pattern collapse preventing agent, a polymer residue removing liquid, a chemical liquid such as a cleaning liquid and the like, and a nanoimprint release agent, which are used for producing a semiconductor; resin compositions for a semiconductor post-process or a printed wiring board (resin compositions such as an epoxy resin, a phenol resin, a polyphenylene ether resin, a liquid crystal polymer, a polyimide resin, a bismaleimide resin, a bisallylnadic imide resin, a benzoxazine resin, and the like), a copper-clad laminate, a resin-coated copper foil, a build-up film, a passivation film, an interlayer insulating film, a flexible copper-clad laminate, and a dry film resist; a color resist for an image sensor; a liquid repellent for a solder flux; a dispersant, a coating material, and a green sheet for a multilayer ceramic capacitor; a cathode material, an anode material, a separator, and an electrolytic solution for a lithium ion battery; an exterior coating material, rubber, an elastomer, glass, a vapor deposition material anchor coat, a head lamp lens, a solid lubricating coating material, a heat radiation substrate, an interior coating material, and a repair coating material for automobile; wall paper, a floor material, a kitchen member, and a bathroom/toil member for housing equipment; an ink jet ink, an offset printing ink, a gravure printing ink, a screen printing ink, a photoresist for a printing plate producing process, a photosensitive material for a planographic printing plate (PS plate), a package adhesive, and an a ballpoint pen ink for printed matter; a primer for plastic film easy adhesion or the like; a water repellent for fibers; a non-diffusion agent for grease; a cleaning solution for cleaning the surfaces of various products or components; a hard coating material for optical recording media such as CD, DVD, a blue-ray disc, and the like; a coating material or hard coating material for a casing or screen for a smartphone or cellular phone; a hard coating material for a transfer film for insert molding (IMD, IMF); a release film; a coating material or coat material for various plastic molded products such as a casing of a home appliance and the like; a printing ink or coating material for various building materials such as a decorative laminated sheet and the like; a coating material for a window glass of housing; a coating material for woodworking for furniture and the like; a coating material for artificial/synthetic leather; a coating material for a rubber roller for OA apparatuses such as a copying machine, a printer, and the like; a coating material for reading part glass of OA apparatuses such as a copying machine, a scanner, and the like; optical lenses such as a camera, a video camera, glasses, a contact lens, and the like or a coating material therefor; a windshield and a coating material for glass of watches such as wrist watch and the like; a coating material for windows of various vehicles such as automobile, a railroad vehicle, and the like; a coting material for an antireflection film of a cover glass or film for a solar cell; a coating material or coat material for a FRP bath; PCM for a metallic building material or a home appliance; a single layer or multilayer coating composition for a photofabrication process and the like; and the like.

The polymer of the present invention has the excellent ability to reduce surface tension, and thus not merely the leveling property but also various functions such as wettability, permeability, washability, water repellency, oil repellency, antifouling property, lubricity, antiblocking property, mold releasability, etc. can be expected. Also, when the polymer of the present invention is mixed with a coating material or coating agent containing fine particles, dispersibility of the fine particles can be improved, and not merely the leveling property but also the function as a dispersant for the fine particles can be expected. In addition, when the polymer of the present invention is added to an adhesive composition used for an adhesive tape or the like other than the coating composition, not merely the leveling property but also various functions of decreasing the peeling force, suppressing variation in the peeling force, and suppressing peeling charge can be expected.

### EXAMPLES

The present invention is specifically described below by examples and comparative examples.

In addition, the present invention is not limited to the examples below.

In the examples and the comparative examples, the weight-average molecular weight (Mw) and number-average molecular weight (Mn) are values in terms of polystyrene based on gel permeation chromatography (GPC) measurement.

The measurement conditions of GPC are as follows.

### [GPC measurement conditions]

Measurement apparatus: high-speed GPC apparatus "HLC-8320GPC" manufactured by Tosoh Corporation
Column: "TSK GUARDCOLUMN SuperHZ-L" manufactured by Tosoh Corporation + "TSK gel SuperHZM-N" manufactured by Tosoh Corporation + "TSK gel SuperHZM-N" manufactured by Tosoh Corporation + "TSK gel SuperHZM-N" manufactured by Tosoh Corporation + "TSK gel SuperHZM-N" manufactured by Tosoh Corporation
Detector: RI (differential refractometer)
Data processing: "EcoSEC Data Analysis Version 1.07" manufactured by Tosoh Corporation
Column temperature: 40°C
Developing solvent: tetrahydrofuran
Flow rate: 0.35 mL/min
Measurement sample: A measurement sample was prepared by dissolving 7.5 mg of sample in 10 ml of tetrahydrofuran and filtering the resultant solution with a microfilter.
Sample injection amount: 20 µl
Standard sample: Monodisperse polystyrene below having known molecular weights according to the measurement manual of "HLC-8320GPC" was used.

### (Monodisperse polystyrene)

"A-300" manufactured by Tosoh Corporation
"A-500" manufactured by Tosoh Corporation
"A-1000" manufactured by Tosoh Corporation
"A-2500" manufactured by Tosoh Corporation
"A-5000" manufactured by Tosoh Corporation
"F-1" manufactured by Tosoh Corporation
"F-2" manufactured by Tosoh Corporation
"F-4" manufactured by Tosoh Corporation
"F-10" manufactured by Tosoh Corporation
"F-20" manufactured by Tosoh Corporation
"F-40" manufactured by Tosoh Corporation
"F-80" manufactured by Tosoh Corporation
"F-128" manufactured by Tosoh Corporation
"F-288" manufactured by Tosoh Corporation

### (SYNTHESIS EXAMPLE 1: synthesis of silicone chain-containing polymer (1))

Mixture A1 was prepared by mixing 180.0 g of polypropylene glycol-polybutylene glycol-monomethacrylate (average repeat number of propylene glycol: 1, average repeat number of butylene glycol: 6) and 70.0 g of butyl acetate as a solvent, mixture B1 was prepared by mixing 3.0 g of tert-butylperoxy-2-ethyl hexanoate as a polymerization initiator and 10.0 g of butyl acetate as a solvent, and mixture C1 was prepared by mixing 20.0 g of monomethacrylate compound having a polysiloxane bond represented by a formula below and 20.0 g of butyl acetate as a solvent. 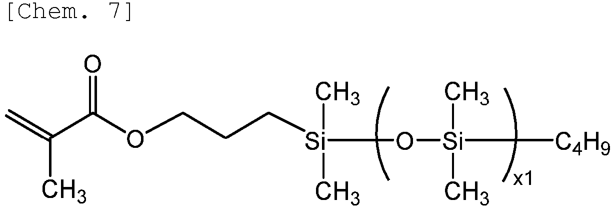 (The average number of x1 is 65.)

In a glass flask provided with a stirrer, a thermometer, a condenser, and a dropping device, 200.0 g of butyl acetate as a solvent was charged and heated to 90°C under stirring in a nitrogen stream.

In the flask, dropping of the mixture A1 at 90°C was started, and 5 minutes after the start of dropping of the mixture A1, dropping of the mixture B1 and the mixture C1 at 90°C was started. The dropping of the mixture C1 was finished 120 minutes after the start of dropping, and the dropping of the mixture A1 and the mixture B1 was finished 10 minutes after (135 minutes after the start of dropping of the mixture A1) the finish of dropping of the mixture C1. After the finish of dropping, the resultant mixture was stirred at 90°C for 10 hours. After the completion of reaction, the solvent was distilled off, producing a silicone chain-containing polymer (1).

As a result of GPC measurement of the molecular weight of the resultant silicone chain-containing polymer (1), the weight-average molecular weight (Mw) was 38,000.

Also, the content ratio of the polymerizable unsaturated monomer having a silicone chain in the silicone chain-containing polymer (1), which was determined from the raw material charge ratio, was 10% by mass.

### (SYNTHESIS EXAMPLE 2: synthesis of silicone chain-containing polymer (2))

Mixture A2 was prepared by mixing 180.0 g of polypropylene glycol-polybutylene glycol-monomethacrylate (average repeat number of propylene glycol: 1, average repeat number of butylene glycol: 6) and 30.0 g of butyl acetate as a solvent, mixture B2 was prepared by mixing 6.0 g of tert-butylperoxy-2-ethyl hexanoate as a polymerization initiator and 20.0 g of butyl acetate as a solvent, and mixture C2 was prepared by mixing 20.0 g of monomethacrylate compound having a polysiloxane bond represented by a formula below and 20.0 g of butyl acetate as a solvent. 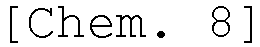 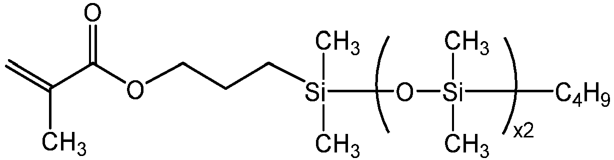 (The average number of x2 is 130.)

In a glass flask provided with a stirrer, a thermometer, a condenser, and a dropping device, 130.0 g of butyl acetate as a solvent was charged and heated to 90°C under stirring in a nitrogen stream.

In the flask, dropping of the mixture A2 at 90°C was started, and 5 minutes after the start of dropping of the mixture A2, dropping of the mixture B2 and the mixture C2 at 90°C was started. The dropping of the mixture C2 was finished 120 minutes after the start of dropping, and the dropping of the mixture A2 and the mixture B2 was finished 30 minutes after (155 minutes after the start of dropping of the mixture A2) the finish of dropping of the mixture C2. After the finish of dropping, the resultant mixture was stirred at 90°C for 10 hours. After the completion of reaction, the solvent was distilled off, producing a silicone chain-containing polymer (2).

As a result of GPC measurement of the molecular weight of the resultant silicone chain-containing polymer (2), the weight-average molecular weight (Mw) was 62,000.

Also, the content ratio of the polymerizable unsaturated monomer having a silicone chain in the silicone chain-containing polymer (2), which was determined from the raw material charge ratio, was 10% by mass.

### (SYNTHESIS EXAMPLE 3: synthesis of silicone chain-containing polymer (3))

Mixture A3 was prepared by mixing 180.0 g of polypropylene glycol monomethacrylate (average repeat number of propylene glycol: 4 to 6) and 61.4 g of butyl acetate as a solvent, mixture B3 was prepared by mixing 6.0 g of Perbutyl O (manufactured by NOF Corporation) as an initiator and 50.0 g of butyl acetate as a solvent, and mixture C3 was prepared by mixing 20.0 g of the same monomethacrylate compound having a polysiloxane bond as in Synthesis Example 1 and 60.0 g of butyl acetate as a solvent.

In a glass flask provided with a stirrer, a thermometer, a condenser, and a dropping device, 200.0 g of butyl acetate as a solvent was charged and heated to 85°C under stirring in a nitrogen stream.

In the flask, dropping of the mixture A3 at 90°C was started, and 5 minutes after the start of dropping of the mixture A3, dropping of the mixture B3 and the mixture C3 at 90°C was started. The dropping of the mixture C3 was finished 120 minutes after the start of dropping, and the dropping of the mixture A3 and the mixture B3 was finished 30 minutes after (155 minutes after the start of dropping of the mixture A3) the finish of dropping of the mixture C3. After the finish of dropping, the resultant mixture was stirred at 95°C for 10 hours. After the completion of reaction, the solvent was distilled off, producing a silicone chain-containing polymer (3).

As a result of GPC measurement of the molecular weight of the resultant silicone chain-containing polymer (3), the weight-average molecular weight (Mw) was 62,000.

Also, the content ratio of the polymerizable unsaturated monomer having a silicone chain in the silicone chain-containing polymer (3), which was determined from the raw material charge ratio, was 10% by mass.

### (SYNTHESIS EXAMPLE 4: synthesis of silicone chain-containing polymer (4))

Mixture A1 was prepared by mixing 180.0 g of polypropylene glycol monomethacrylate (average repeat number of propylene glycol: 4 to 6) and 30.0 g of butyl acetate as a solvent, mixture B4 was prepared by mixing 6.0 g of tert-butylperoxy-2-ethyl hexanoate as an initiator and 20.0 g of butyl acetate as a solvent, and mixture C4 was prepared by mixing 20.0 g of the same monomethacrylate compound having a polysiloxane bond as in Synthesis Example 2 and 20.0 g of butyl acetate as a solvent.

In a glass flask provided with a stirrer, a thermometer, a condenser, and a dropping device, 130.0 g of butyl acetate as a solvent was charged and heated to 95°C under stirring in a nitrogen stream.

In the flask, dropping of the mixture A4 at 90°C was started, and 5 minutes after the start of dropping of the mixture A4, dropping of the mixture B4 and the mixture C4 at 90°C was started. The dropping of the mixture C4 was finished 120 minutes after the start of dropping, and the dropping of the mixture A4 and the mixture B4 was finished 30 minutes after (155 minutes after the start of dropping of the mixture A4) the finish of dropping of the mixture C4. After the finish of dropping, the resultant mixture was stirred at 95°C for 10 hours. After the completion of reaction, the solvent was distilled off, producing a silicone chain-containing polymer (4).

As a result of GPC measurement of the molecular weight of the resultant silicone chain-containing polymer (4), the weight-average molecular weight (Mw) was 51,000.

Also, the content ratio of the polymerizable unsaturated monomer having a silicone chain in the silicone chain-containing polymer (4), which was determined from the raw material charge ratio, was 10% by mass.

### (SYNTHESIS EXAMPLE 5: synthesis of silicone chain-containing polymer (5))

Mixture A5 was prepared by mixing 180.0 g of polypropylene glycol-polybutylene glycol-monomethacrylate (average repeat number of propylene glycol: 1, average repeat number of butylene glycol: 6) and 50.0 g of propylene glycol monomethyl ether acetate (PGMEA) as a solvent, mixture B5 was prepared by mixing 2.0 g of tert-butylperoxy-2-ethyl hexanoate as an initiator and 30.0 g of PGMEA as a solvent, and mixture C5 was prepared by mixing 20.0 g of the same monomethacrylate compound having a polysiloxane bond as in Synthesis Example 1 and 20.0 g of propylene glycol monomethyl ether acetate (PGMEA) as a solvent.

In a glass flask provided with a stirrer, a thermometer, a condenser, and a dropping device, 200.0 g of PGMEA as a solvent was charged and heated to 85°C under stirring in a nitrogen stream.

In the flask, dropping of the mixture A5 at 85°C was started, and 5 minutes after the start of dropping of the mixture A5, dropping of the mixture B5 and the mixture C5 at 85°C was started. The dropping of the mixture C5 was finished 120 minutes after the start of dropping, and the dropping of the mixture A5 and the mixture B5 was finished 10 minutes after (135 minutes after the start of dropping of the mixture A5) the finish of dropping of the mixture C5. After the finish of dropping, the resultant mixture was stirred at 85°C for 5 hours and then stirred at 110°C for 1 hour. After the completion of reaction, the solvent was distilled off, producing a silicone chain-containing polymer (5) .

As a result of GPC measurement of the molecular weight of the resultant silicone chain-containing polymer (5), the weight-average molecular weight (Mw) was 21,000.

Also, the content ratio of the polymerizable unsaturated monomer having a silicone chain in the silicone chain-containing polymer (5), which was determined from the raw material charge ratio, was 10% by mass.

### (SYNTHESIS EXAMPLE 6: synthesis of silicone chain-containing polymer (6))

Mixture A6 was prepared by mixing 160.0 g of polypropylene glycol-polybutylene glycol-monomethacrylate (average repeat number of propylene glycol: 1, average repeat number of butylene glycol: 6) and 30.0 g of PGMEA as a solvent, mixture B6 was prepared by mixing 2.0 g of tert-butylperoxy-2-ethyl hexanoate and 30.0 g of PGMEA as a solvent, and mixture C6 was prepared by mixing 40.0 g of the same monomethacrylate compound having a polysiloxane bond as in Synthesis Example 1 and 40.0 g of PGMEA as a solvent.

In a glass flask provided with a stirrer, a thermometer, a condenser, and a dropping device, 200.0 g of PGMEA as a solvent was charged and heated to 85°C under stirring in a nitrogen stream.

In the flask, dropping of the mixture A6 at 85°C was started, and 5 minutes after the start of dropping of the mixture A6, dropping of the mixture B6 and the mixture C6 at 85°C was started. The dropping of the mixture C6 was finished 120 minutes after the start of dropping, and the dropping of the mixture A6 and the mixture B6 was finished 10 minutes after (135 minutes after the start of dropping of the mixture A6) the finish of dropping of the mixture C6. After the finish of dropping, the resultant mixture was stirred at 85°C for 5 hours and then stirred at 110°C for 1 hour. After the completion of reaction, the solvent was distilled off, producing a silicone chain-containing polymer (6) .

As a result of GPC measurement of the molecular weight of the resultant silicone chain-containing polymer (6), the weight-average molecular weight (Mw) was 21,000.

Also, the content ratio of the polymerizable unsaturated monomer having a silicone chain in the silicone chain-containing polymer (6), which was determined from the raw material charge ratio, was 20% by mass.

### (SYNTHESIS EXAMPLE 7: synthesis of silicone chain-containing polymer (7))

Mixture A7 was prepared by mixing 180.0 g of polypropylene glycol monomethacrylate (average repeat number of propylene glycol: 4 to 6) and 60.43 g of butyl acetate as a solvent, mixture B7 was prepared by mixing 2.0 g of tert-butylperoxy-2-ethyl hexanoate as an initiator and 50.0 g of butyl acetate as a solvent, and mixture C7 was prepared by mixing 20.0 g of the same monomethacrylate compound having a polysiloxane bond as in Synthesis Example 1 and 60.0 g of butyl acetate as a solvent.

In a glass flask provided with a stirrer, a thermometer, a condenser, and a dropping device, 200.0 g of butyl acetate as a solvent was charged and heated to 85°C under stirring in a nitrogen stream.

In the flask, dropping of the mixture A7 at 85°C was started, and 5 minutes after the start of dropping of the mixture A7, dropping of the mixture B7 and the mixture C7 at 85°C was started. The dropping of the mixture C7 was finished 120 minutes after the start of dropping, and the dropping of the mixture A7 and the mixture B7 was finished 10 minutes after (135 minutes after the start of dropping of the mixture A7) the finish of dropping of the mixture C7. After the finish of dropping, the resultant mixture was stirred at 85°C for 5 hours and then stirred at 110°C for 1 hour. After the completion of reaction, the solvent was distilled off, producing a silicone chain-containing polymer (7) .

As a result of GPC measurement of the molecular weight of the resultant silicone chain-containing polymer (7), the weight-average molecular weight (Mw) was 25,000.

Also, the content ratio of the polymerizable unsaturated monomer having a silicone chain in the silicone chain-containing polymer (7), which was determined from the raw material charge ratio, was 10% by mass.

### (SYNTHESIS EXAMPLE 8: synthesis of silicone chain-containing polymer (8))

Mixture A8 was prepared by mixing 75.0 g of polypropylene glycol-polybutylene glycol-monomethacrylate (average repeat number of propylene glycol: 1, average repeat number of butylene glycol: 6) 5.0 g of methacrylic acid, and 35.71 g of propylene glycol monomethyl ether acetate (PGMEA) as a solvent, mixture B8 was prepared by mixing 1.0 g of tert-butylperoxy-2-ethyl hexanoate as an initiator and 30.0 g of PGMEA as a solvent, and mixture C8 was prepared by mixing 20.0 g of the same monomethacrylate compound having a polysiloxane bond as in Synthesis Example 1 and 20.0 g of PGMEA as a solvent.

In a glass flask provided with a stirrer, a thermometer, a condenser, and a dropping device, 100.0 g of PGMEA as a solvent was charged and heated to 90°C under stirring in a nitrogen stream.

In the flask, dropping of the mixture A8 at 90°C was started, and 5 minutes after the start of dropping of the mixture A8, dropping of the mixture B8 and the mixture C8 at 90°C was started. The dropping of the mixture C8 was finished 120 minutes after the start of dropping, and the dropping of the mixture A8 and the mixture B8 was finished 10 minutes after (135 minutes after the start of dropping of the mixture A8) the finish of dropping of the mixture C8. After the finish of dropping, the resultant mixture was stirred at 90°C for 5 hours and then stirred at 110°C for 1 hour. After the completion of reaction, the solvent was distilled off, producing a silicone chain-containing polymer (8) .

As a result of GPC measurement of the molecular weight of the resultant silicone chain-containing polymer (8), the weight-average molecular weight (Mw) was 26,000.

Also, the content ratio of the polymerizable unsaturated monomer having a silicone chain in the silicone chain-containing polymer (8), which was determined from the raw material charge ratio, was 20% by mass.

### (SYNTHESIS EXAMPLE 9: synthesis of silicone chain-containing polymer (9))

Mixture A9 was prepared by mixing 245.45 g of polyethylene glycol-polypropylene glycol-monomethacrylate (average repeat number of polyethylene glycol: 22, average repeat number of propylene glycol: 22), mixture B9 was prepared by mixing 11.25 g of tert-butylperoxy-2-ethyl hexanoate and 14.55 g of PGMEA as a solvent, and mixture C9 was prepared by mixing 15 g of the same monomethacrylate compound having a polysiloxane bond as in Synthesis Example 1 and 25 g of PGMEA as a solvent.

In a glass flask provided with a stirrer, a thermometer, a condenser, and a dropping device, 300 g of PGMEA as a solvent was charged and heated to 100°C under stirring in a nitrogen stream.

In the flask, dropping of the mixture A9 at 100°C was started, and 5 minutes after the start of dropping of the mixture A9, dropping of the mixture B9 and the mixture C9 at 100°C was started. The dropping of the mixture C9 was finished 120 minutes after the start of dropping, and the dropping of the mixture A9 and the mixture B9 was finished 10 minutes after (135 minutes after the start of dropping of the mixture A9) the finish of dropping of the mixture C9. After the finish of dropping, the resultant mixture was stirred at 100°C for 5 hours. After the completion of reaction, the solvent was distilled off, producing a silicone chain-containing polymer (9).

As a result of GPC measurement of the molecular weight of the resultant silicone chain-containing polymer (9), the weight-average molecular weight (Mw) was 35,000.

Also, the content ratio of the polymerizable unsaturated monomer having a silicone chain in the silicone chain-containing polymer (9), which was determined from the raw material charge ratio, was 10% by mass.

### (SYNTHESIS COMPARATIVE EXAMPLE 1: synthesis of silicone chain-containing polymer (1'))

Mixture A1' was prepared by mixing 160.0 g of polypropylene glycol-polybutylene glycol-monomethacrylate (average repeat number of propylene glycol: 1, average repeat number of butylene glycol: 6) and 70.0 g of butyl acetate as a solvent, mixture B1' was prepared by mixing 3.0 g of tert-butylperoxy-2-ethyl hexanoate as an initiator and 156.7 g of butyl acetate as a solvent, and mixture C1' was prepared by mixing 40.0 g of the same monomethacrylate compound having a polysiloxane bond as in Synthesis Example 1 and 40.0 g of butyl acetate as a solvent.

In a glass flask provided with a stirrer, a thermometer, a condenser, and a dropping device, 200.0 g of butyl acetate as a solvent was charged and heated to 90°C under stirring in a nitrogen stream.

In the flask, dropping of the mixture A1' at 90°C was started, and 5 minutes after the start of dropping of the mixture A1', dropping of the mixture B1' and the mixture C1' at 90°C was started. The dropping of the mixture C1' was finished 120 minutes after the start of dropping, and the dropping of the mixture A1' and the mixture B1' was finished 10 minutes after (135 minutes after the start of dropping of the mixture A1') the finish of dropping of the mixture C1'. After the finish of dropping, the resultant mixture was stirred at 90°C for 10 hours. After the completion of reaction, the solvent was distilled off, producing a silicone chain-containing polymer (1').

As a result of GPC measurement of the molecular weight of the resultant silicone chain-containing polymer (1'), the weight-average molecular weight (Mw) was 13,000.

Also, the content ratio of the polymerizable unsaturated monomer having a silicone chain in the silicone chain-containing polymer (1'), which was determined from the raw material charge ratio, was 20% by mass.

### (SYNTHESIS COMPARATIVE EXAMPLE 2: synthesis of silicone chain-containing polymer (2'))

Mixture A2' was prepared by mixing 136.8 g of polypropylene glycol-polybutylene glycol-monomethacrylate (average repeat number of propylene glycol: 1, average repeat number of butylene glycol: 6) and 50.0 g of butyl acetate as a solvent, mixture B2' was prepared by mixing 3.0 g of tert-butylperoxy-2-ethyl hexanoate as an initiator and 20.0 g of butyl acetate as a solvent, and mixture C2' was prepared by mixing 63.2 g of the same monomethacrylate compound having a polysiloxane bond as in Synthesis Example 1 and 30.0 g of butyl acetate as a solvent.

In a glass flask provided with a stirrer, a thermometer, a condenser, and a dropping device, 200.0 g of butyl acetate as a solvent was charged and heated to 90°C under stirring in a nitrogen stream.

In the flask, dropping of the mixture A2' at 90°C was started, and 5 minutes after the start of dropping of the mixture A2', dropping of the mixture B2' and the mixture C2' at 90°C was started. The dropping of the mixture C2' was finished 120 minutes after the start of dropping, and the dropping of the mixture A2' and the mixture B2' was finished 10 minutes after (135 minutes after the start of dropping of the mixture A2') the finish of dropping of the mixture C2'. After the finish of dropping, the resultant mixture was stirred at 90°C for 10 hours. After the completion of reaction, the solvent was distilled off, producing a silicone chain-containing polymer (2').

As a result of GPC measurement of the molecular weight of the resultant silicone chain-containing polymer (2'), the weight-average molecular weight (Mw) was 34,000.

Also, the content ratio of the polymerizable unsaturated monomer having a silicone chain in the silicone chain-containing polymer (2'), which was determined from the raw material charge ratio, was 31.6% by mass.

### (SYNTHESIS COMPARATIVE EXAMPLE 3: synthesis of silicone chain-containing polymer (3'))

Mixture A3' was prepared by mixing 136.8 g of polypropylene glycol-polybutylene glycol-monomethacrylate (average repeat number of propylene glycol: 1, average repeat number of butylene glycol: 6) and 102.8 g of butyl acetate as a solvent, mixture B3' was prepared by mixing 3.0 g of tert-butylperoxy-2-ethyl hexanoate as an initiator and 100.0 g of butyl acetate as a solvent, and mixture C3' was prepared by mixing 63.2 g of the same monomethacrylate compound having a polysiloxane bond as in Synthesis Example 1 and 63.2 g of butyl acetate as a solvent.

In a glass flask provided with a stirrer, a thermometer, a condenser, and a dropping device, 200.0 g of butyl acetate as a solvent was charged and heated to 90°C under stirring in a nitrogen stream.

In the flask, dropping of the mixture A3' at 90°C was started, and 5 minutes after the start of dropping of the mixture A3', dropping of the mixture B3' and the mixture C3' at 90°C was started. The dropping of the mixture C3' was finished 120 minutes after the start of dropping, and the dropping of the mixture A3' and the mixture B3' was finished 10 minutes after (135 minutes after the start of dropping of the mixture A3') the finish of dropping of the mixture C3'. After the finish of dropping, the resultant mixture was stirred at 90°C for 10 hours. After the completion of reaction, the solvent was distilled off, producing a silicone chain-containing polymer (3').

As a result of GPC measurement of the molecular weight of the resultant silicone chain-containing polymer (3'), the weight-average molecular weight (Mw) was 14,000.

Also, the content ratio of the polymerizable unsaturated monomer having a silicone chain in the silicone chain-containing polymer (3'), which was determined from the raw material charge ratio, was 31.6% by mass.

### (SYNTHESIS COMPARATIVE EXAMPLE 4: synthesis of silicone chain-containing polymer (4'))

Mixture A4' was prepared by mixing 180.0 g of polypropylene glycol-polybutylene glycol-monomethacrylate (average repeat number of propylene glycol: 1, average repeat number of butylene glycol: 6) and 60.43 g of butyl acetate as a solvent, mixture B4' was prepared by mixing 2.0 g of tert-butylperoxy-2-ethyl hexanoate as an initiator and 50.0 g of butyl acetate as a solvent, and mixture C4' was prepared by mixing 20.0 g of monomethacrylate compound having a polysiloxane bond represented by formula below and 60.0 g of butyl acetate as a solvent. 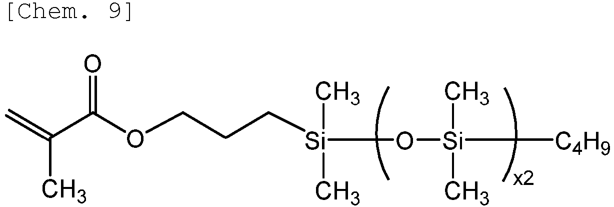 (The average number of x2 is 10.)

In a glass flask provided with a stirrer, a thermometer, a condenser, and a dropping device, 200.0 g of butyl acetate as a solvent was charged and heated to 85°C under stirring in a nitrogen stream.

In the flask, dropping of the mixture A4' at 85°C was started, and 5 minutes after the start of dropping of the mixture A4', dropping of the mixture B4' and the mixture C4' at 85°C was started. The dropping of the mixture C4' was finished 120 minutes after the start of dropping, and the dropping of the mixture A4' and the mixture B4' was finished 10 minutes after (135 minutes after the start of dropping of the mixture A4') the finish of dropping of the mixture C4'. After the finish of dropping, the resultant mixture was stirred at 85°C for 5 hours and then stirred at 110°C for 1 hour. After the completion of reaction, the solvent was distilled off, producing a silicone chain-containing polymer (4').

As a result of GPC measurement of the molecular weight of the resultant silicone chain-containing polymer (4'), the weight-average molecular weight (Mw) was 32,000.

Also, the content ratio of the polymerizable unsaturated monomer having a silicone chain in the silicone chain-containing polymer (4'), which was determined from the raw material charge ratio, was 10.0% by mass.

### (SYNTHESIS COMPARATIVE EXAMPLE 5: synthesis of silicone chain-containing polymer (5'))

Mixture A5' was prepared by mixing 80.0 g of polypropylene glycol monomethacrylate (average repeat number of propylene glycol: 4 to 6), and 35.71 g of propylene glycol monomethyl ether acetate (PGMEA) as a solvent, mixture B5' was prepared by mixing 1.0 g of tert-butylperoxy-2-ethyl hexanoate as an initiator and 30.0 g of PGMEA as a solvent, and mixture C5' was prepared by mixing 20.0 g of the same monomethacrylate compound having a polysiloxane bond as in Synthesis Comparative Example 4 and 20.0 g of PGMEA as a solvent.

In a glass flask provided with a stirrer, a thermometer, a condenser, and a dropping device, 100.0 g of PGMEA as a solvent was charged and heated to 90°C under stirring in a nitrogen stream.

In the flask, dropping of the mixture A5' at 90°C was started, and 5 minutes after the start of dropping of the mixture A5', dropping of the mixture B5' and the mixture C8 at 90°C was started. The dropping of the mixture C5' was finished 120 minutes after the start of dropping, and the dropping of the mixture A5' and the mixture B5' was finished 10 minutes after (135 minutes after the start of dropping of the mixture A5') the finish of dropping of the mixture C8. After the finish of dropping, the resultant mixture was stirred at 90°C for 5 hours and then stirred at 110°C for 1 hour. After the completion of reaction, the solvent was distilled off, producing a silicone chain-containing polymer (5').

As a result of GPC measurement of the molecular weight of the resultant silicone chain-containing polymer (5'), the weight-average molecular weight (Mw) was 34,000.

Also, the content ratio of the polymerizable unsaturated monomer having a silicone chain in the silicone chain-containing polymer (5'), which was determined from the raw material charge ratio, was 20% by mass.

### (EXAMPLE 1: Formation of coating film and evaluation of smoothness)

A coating film was formed by using the silicone chain-containing polymer (1) produced in Synthesis Example 1 as described below.

A resist composition was prepared by mixing 3.0 g of a 40 mass% resin solution of an alkali-soluble resin (Acrydic ZL-295, manufactured by DIC Corporation), 1.2 g of Aronix M-402 (manufactured by Toagosei Chemical Co., Ltd., a mixture of dipentaerythritol pentaacrylate and dipentaerythritol hexaacrylate), 0.0024 g in terms of solid content of the silicone chain-containing polymer (1), and 6.23 g of propylene glycol monomethyl ether acetate (PGMEA).

Then, 3 ml of the resultant resist composition was dropped on a central portion of a chromium-plated glass substrate of 10 cm × 10 cm, spin-coated under the conditions including a rotational speed of 1000 rpm and a rotation time of 10 seconds, and then dried by heating at 100°C for 100 seconds using a hot plate, forming a laminate having a coating film layer.

The smoothness and coating film defect of the coating film layer of the resultant laminate were evaluated by methods described below. The results are shown in Table 1.

### (Smoothness)

The coating film layer of the resultant laminate was visually observed and the smoothness of the coating film layer was evaluated according to criteria below.
A: Substantially no unevenness was observed in the coating film.
B: Unevenness was partially observed in the coating film.
C: Unevenness was observed over the whole of the coating film.

### (Coating film defect)

The coating film layer of the resultant laminate was visually observed and the coating film defects of the coating film layer were evaluated according to criteria below.
1: Substantially no defect was observed in the coating film.
2: Several defects were observed in the coating film.
3: Many defects were observed over the whole of the coating film.

### (EXAMPLES 2 to 9 and COMPARATIVE EXAMPLES 1 to 3)

The same evaluation as in Example 1 was performed except that each of the polymers produced in Synthesis Examples 2 to 9 and Synthesis Comparative Examples 1 to 3 was used in place of the silicone chain-containing polymer (1). The results are shown in Table 1.

**[Table 1]**

| | Example 1 | Example 2 | Example 3 | Example 4 | Example 5 | Example 6 | Example 7 | Example 8 | Example 9 | Comparative Example1 | Comparative Example 2 | Comparative Example 3 |
|---|---|---|---|---|---|---|---|---|---|---|---|---|
| Silicone chain-containing polymer | 1 | 2 | 3 | 4 | 5 | 6 | 7 | 8 | 9 | 1' | 2' | 3' |
| Smooth-ness | A | A | A | A | A | A | A | A | A | A | A | A |
| Coating film defect | 1 | 1 | 1 | 1 | 1 | 1 | 1 | 1 | 1 | 2 | 3 | 3 |

It was found that the coating films of Examples 1 to 4 containing the silicone chain-containing polymer of the present invention as a leveling agent have the excellent smoothness and no coating film defects. On the other hand, in Comparative Example 1 using the silicone chain-containing polymer having a small weight-average molecular weight, coating film defects (cissing) occur. Similarly, in Comparative Example 2 using the polymer containing a large amount of silicone chains, coating defects occur. Also, in Comparative Example 3 using the silicone chain-containing polymer having a low weight-average molecular weight and a large amount of silicone chains, coating film defects occur.

### (EXAMPLES 10 to 14 and COMPARATIVE EXAMPLES 4 to 5: evaluation of pin unevenness)

A coating film was formed by using each of the silicone chain-containing polymers produced in Synthesis Examples 1 to 4 and 9 and Synthesis Comparative Examples 4 and 5 as described below.

A resist composition was prepared by mixing 3.0 g of a 40 mass% resin solution of an alkali-soluble resin (Acrydic ZL-295, manufactured by DIC Corporation), 1.2 g of Aronix M-402 (manufactured by Toagosei Chemical Co., Ltd., mixture of dipentaerythritol pentaacrylate and dipentaerythritol hexaacrylate), 0.0024 g in terms of solid content of the silicone chain-containing polymer, and 6.23 g of propylene glycol monomethyl ether acetate (PGMEA).

Then, 3 ml of the resultant resist composition was dropped on a central portion of a chromium-plated glass substrate of 10 cm × 10 cm and spin-coated under the conditions including a rotational speed of 1000 rpm and a rotation time of 10 seconds, producing a coated substrate. SUS-made pins were provided at the four corners of a hot plate, and the resultant coated substrate was placed on the support pints and then dried by heating at 100°C for 100 seconds, forming a laminate having a coating film layer.

### (Evaluation of pin unevenness)

The coating film layer of the resultant laminate was visually observed, and pin unevenness of the coating film layer was evaluated according to criteria below. The results are shown in Table 2. The "pin unevenness" represents film thickness unevenness (drying unevenness) produced around, as a center, a contact portion between each of the support pins and the substrate.
1: Substantially no pin unevenness is observed.
2: Pin unevenness is observed.

**[Table 2]**

| | Example 10 | Example 11 | Example 12 | Example 13 | Example 14 | Comparative Example 4 | Comparative Example 5 |
|---|---|---|---|---|---|---|---|
| Silicone chain-containing polymer | 1 | 2 | 3 | 4 | 9 | 4' | 5' |
| Pin unevenness | 1 | 1 | 1 | 1 | 1 | 2 | 2 |

It is found that substantially no unevenness occurs in the coating films of Example 10 to 14 containing the silicone chain-containing polymer of the present invention as a leveling agent. On the other hand, pin unevenness occurs in the coating films of Comparative Examples 4 and 5 containing as a leveling agent the silicone chain-containing polymer having little repeating units of siloxane bond (short silicone chain).

## Claims

1. A silicone chain-containing polymer comprising as polymerization components a polymerizable monomer (1) having a group containing a structure represented by general formula(A) below and a polymerizable monomer (2) having one or more selected from an alkyl group having 1 to 18 carbon atoms, an aromatic group having 6 to 18 carbon atoms, and a group containing a polyoxyalkylene chain,
wherein the ratio of the polymerizable monomer (1) in the polymerization components is 20% by weight or less; and
the weight-average molecular weight is 15,000 or more, 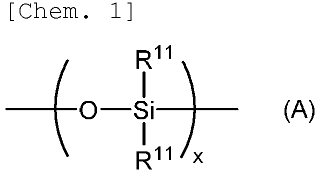
(in the formula (A),
R¹¹s are each independently an alkyl group having 1 to 6 carbon atoms, x represents a repeat number; and
an average number value thereof is 20 or more).

2. The silicone chain-containing polymer according to Claim 1, wherein the group containing a structure represented by the general formula (A) is a group represented by general formula (A1) below, 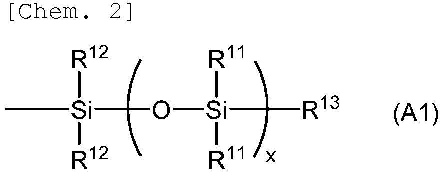
(in the formula (A1),
R¹¹s are each independently an alkyl group having 1 to 6 carbon atoms;
R¹²s are each independently an alkyl group having 1 to 6 carbon atoms;
R¹³ is an alkyl group having 1 to 6 carbon atoms; and x represents a repeat number, and an average number value thereof is 20 or more).

3. The silicone chain-containing polymer according to Claim 1 or 2, wherein the polymerizable monomer (1) is a compound represented by general formula (1-1) below, 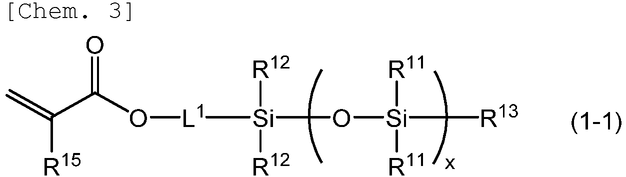 (in the general formula (1-1),
R²¹s are each independently an alkyl group having 1 to 6 carbon atoms;
R¹²s are each independently an alkyl group having 1 to 6 carbon atoms;
R¹³ is an alkyl group having 1 to 6 carbon atoms;
x represents a repeat number, and an average number value thereof is 20 or more;
R¹⁵ is a hydrogen atom or a methyl group; and
L¹ is a divalent organic group).

4. The silicone chain-containing polymer according to any one of Claims 1 to 3, wherein the polymerizable monomer (2) is preferably a compound represented by general formula (2-1) below and/or a compound represented by general formula (2-2) below, 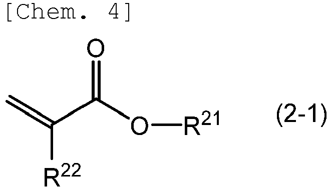 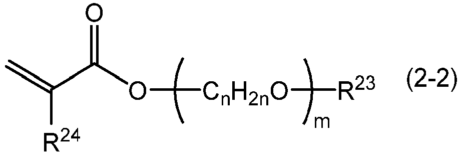
(in the general formulae (2-1) and (2-2),
R²¹ is an alkyl group having 1 to 18 carbon atoms;
R²² is a hydrogen atom or a methyl group;
R²³ is a hydrogen atom or an alkyl group having 1 to 18 carbon atoms;
R²⁴ is a hydrogen atom or a methyl group; and
n is an integer within a range of 1 to 4, and m is an integer within a range of 1 to 200).

5. The silicone chain-containing polymer according to any one of Claims 1 to 4, wherein the polymerizable monomer (1) and the polymerizable monomer (2) are 80% by mass or more of the polymerization components.

6. The silicone chain-containing polymer according to any one of Claims 1 to 5, wherein the polymer does not contain a fluorine atom.

7. A method for producing a silicone chain-containing polymer, comprising:
starting addition of a polymerizable monomer (1) having a group containing a structure represented by general formula (A) below to a reaction system;
after the start of addition of the polymerizable monomer (1), adding a polymerizable monomer (2) having one or more selected from an alkyl group having 1 to 18 carbon atoms, an aromatic group having 6 to 18 carbon atoms, and a group containing a polyoxyalkylene chain and polymerization initiator to the reaction system and starting polymerization: and
finishing the addition of the polymerizable monomer (1) to the reaction system before the polymerizable monomer (2) and the polymerization initiator, 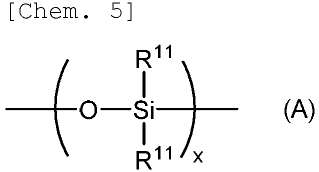
(in the formula (A),
R¹¹s are each independently an alkyl group having 1 to 6 carbon atoms;
x represents a repeat number; and
an average number value thereof is 20 or more).

8. A coating composition comprising the silicone chain-containing polymer according to any one of Claims 1 to 6.

9. A resist composition comprising the silicone chain-containing polymer according to any one of Claims 1 to 6.

10. An article comprising the silicone chain-containing polymer according to any one of Claims 1 to 6.
